# EUROPEAN PATENT APPLICATION

(11) **EP 4 651 195 A1**
(43) Date of publication of application: **19.11.2025**
(21) Application number: 25159075.8
(22) Date of filing: 20.02.2025
(51) Int. Cl.: H01L 21/768, H01L 23/485, H01L 23/528, H10D 64/23, H10D 30/40

(54) **SEMICONDUCTOR DEVICE**

(30) Priority: 14.05.2024 KR 20240063205
(71) Applicant: Samsung Electronics Co., Ltd., Suwon-si, Gyeonggi-do 16677 (KR)
(72) Inventor: JUNG, Seung Geun, 16677 Suwon-si (KR); KANG, Myung Gil, 16677 Suwon-si (KR); NOH, Chang Woo, 16677 Suwon-si (KR)
(74) Representative: Marks & Clerk LLP

(57) **Abstract**

Provided is a semiconductor device including: a substrate; an active pattern on an upper side of the substrate; a gate structure on and intersecting the active pattern ; a source/drain pattern on a side face of the gate structure and connected to the active pattern; an etch stop layer extending along an upper side of the substrate and an outer face of the source/drain pattern; a back side source/drain contact in the substrate, the back side source/drain contact being connected to the source/drain pattern; and a back side wiring structure on a lower side of the substrate and connected to the back side source/drain contact, wherein the back side source/drain contact extends along a part of a side face of the source/drain pattern, and wherein a part of the back side source/drain contact farthest from the lower side of the substrate is in contact with the etch stop layer.

## Description

### BACKGROUND

### 1. Field

The present disclosure relates to a semiconductor device and a method for fabricating the same. More specifically, the present disclosure relates to a semiconductor device including a back side power delivery network (BSPDN) and a method for fabricating the same.

### 2. Description of Related Art

Due to factors such as miniaturization, multi-functionality and/or low fabricating cost, semiconductor devices are in the spotlight as important elements in the electronics industry. Semiconductor devices may be classified into semiconductor memory devices that store logical data, semiconductor logic devices that perform computation processing on logical data, hybrid semiconductor devices including both memory elements and logic elements, and the like.

As the electronics industry has developed, the demands for the features of semiconductor devices has gradually increased. For example, the demands for high reliability, high speed and/or multi-functionality of semiconductor devices has gradually increased. In order to satisfy such required characteristics, the structure inside semiconductor devices is becoming increasingly complex and highly integrated.

However, as semiconductor devices become increasingly highly integrated, the width of wiring patterns and via patterns that realize the semiconductor device must continue to decrease. For this reason, voltage drop (e.g., IR drop) of a power distribution network (PDN) that supplies the power supply voltage to the integrated circuit have become an important problem.

### SUMMARY

Provided is a semiconductor device having improved PPAC (Power, Performance, Area, and Cost) characteristics.

Also provided is a method for fabricating a semiconductor device having improved PPAC characteristics.

According to an aspect of the disclosure, a semiconductor device includes: a substrate; an active pattern on an upper side of the substrate; a gate structure on the active pattern and intersecting the active pattern; a source/drain pattern on a side face of the gate structure and connected to the active pattern; an etch stop layer extending along an upper side of the substrate and an outer face of the source/drain pattern; a back side source/drain contact in the substrate, the back side source/drain contact being connected to the source/drain pattern; and a back side wiring structure on a lower side of the substrate and connected to the back side source/drain contact, wherein the back side source/drain contact extends along at least a part of a side face of the source/drain pattern, and wherein a part of the back side source/drain contact farthest from the lower side of the substrate is in contact with the etch stop layer.

According to an aspect of the disclosure, a semiconductor device includes: a substrate; an active pattern on an upper side of the substrate and extending in a first direction; a gate structure on the active pattern and extending in a second direction intersecting the first direction; a source/drain pattern on a side face of the gate structure and connected to the active pattern; an etch stop layer extending along the upper side of the substrate and an outer face of the source/drain pattern; a back side wiring structure on a lower side of the substrate; and a back side source/drain contact which connects the source/drain pattern and the back side wiring structure, wherein the back side source/drain contact includes: a first pillar in the substrate, the first pillar being in contact with a lower face of the source/drain pattern; and a first wrapping part which protrudes beyond an upper face of the first pillar and extends along at least a part of a side face of the source/drain pattern, and wherein the first wrapping part is in contact with the etch stop layer.

According to an aspect of the disclosure, a semiconductor device includes; a substrate; a plurality of bridge patterns which are sequentially stacked on an upper side of the substrate, are spaced apart from each other, and extend in a first direction; a gate structure which extends in a second direction intersecting the first direction, wherein the plurality of bridge patterns are in the gate structure; a source/drain pattern on a side face of the gate structure and connected to the plurality of bridge patterns; an etch stop layer extending along the upper side of the substrate, the side face of the gate structure, and an outer face of the source/drain pattern; a back side wiring structure on a lower side of the substrate; and a back side source/drain contact which connects the source/drain pattern and the back side wiring structure, wherein the source/drain pattern includes a first epitaxial layer and a second epitaxial layer, where in the first and the second epitaxial layers are sequentially stacked on the substrate and the plurality of bridge patterns, wherein an impurity concentration of the second epitaxial layer is larger than an impurity concentration of the first epitaxial layer, wherein the back side source/drain contact includes: a first pillar in the substrate, the first pillar being in contact with a lower face of the source/drain pattern; and a first wrapping part that protrudes beyond an upper face of the first pillar, wherein the first wrapping part extends along a part of a side face of the second epitaxial layer, and wherein the etch stop layer extends from an upper face of the first wrapping part along a part of the side face of the second epitaxial layer different from the part of the side face of the second epitaxial layer along which the first wrapping part extends.

However, the present disclosure is not restricted to the one or more embodiments set forth herein. The above and other aspects of the present disclosure will become more apparent to one of ordinary skill in the art to which the present disclosure pertains by referencing the detailed description of the present disclosure given below.

At least some of the above and other features of the invention are set out in the claims.

### BRIEF DESCRIPTION OF DRAWINGS

The above and other aspects and features of certain embodiments of the present disclosure will be more apparent from the following description taken in conjunction with the accompanying drawings, in which:
FIG. 1 is an example layout diagram for explaining a semiconductor device according to one or more embodiments of the present disclosure;
FIG. 2 is a schematic cross-sectional view taken along A-A of FIG. 1;
FIG. 3 is a schematic cross-sectional view taken along B-B of FIG. 1;
FIG. 4 is a schematic cross-sectional view taken along C-C of FIG. 1;
FIG. 5 is a schematic cross-sectional view taken along D-D of FIG. 1;
FIG. 6 is an enlarged view for explaining a region R1 of FIG. 5;
FIGS. 7 to 16 are various diagrams for explaining a semiconductor device according to one or more embodiments of the present disclosure;
FIGS. 17 to 43 are intermediate stage diagrams for explaining the method for fabricating the semiconductor device according to one or more embodiments of the present disclosure; and
FIGS. 44 to 47 are intermediate stage diagrams for explaining a method for fabricating a semiconductor device according to one or more embodiments of the present disclosure.

### DETAILED DESCRIPTION

In the following description, like reference numerals refer to like elements throughout the specification.

Although terms such as first and second are used to describe various elements or components in the present specification, it goes without saying that these elements or components are not limited by these terms. These terms are only used to distinguish a single element or component from other elements or components. Therefore, it goes without saying that a first element or component referred to below may be a second element or component within the technical idea of the present disclosure.

As used herein, a plurality of "units", "modules", "members", and "blocks" may be implemented as a single component, or a single "unit", "module", "member", and "block" may include a plurality of components.

It will be understood that when an element is referred to as being "connected" with or to another element, it can be directly or indirectly connected to the other element.

Also, when a part "includes" or "comprises" an element, unless there is a particular description contrary thereto, the part may further include other elements, not excluding the other elements.

Throughout the description, when a member is "on" another member, this includes not only when the member is in contact with the other member, but also when there is another member between the two members.

As used herein, the expressions "at least one of a, b or c" and "at least one of a, b and c" indicate "only a," "only b," "only c," "both a and b," "both a and c," "both b and c," and "all of a, b, and c."

As used herein, the singular forms "a," "an" and "the" are intended to include the plural forms as well, unless the context clearly indicates otherwise.

With regard to any method or process described herein, an identification code may be used for the convenience of the description but is not intended to illustrate the order of each step or operation. Each step or operation may be implemented in an order different from the illustrated order unless the context clearly indicates otherwise. One or more steps or operations may be omitted unless the context of the disclosure clearly indicates otherwise.

Further, in this specification, although only MBCFET^{®} including a multi-bridge channel are shown as example electronic elements included in the semiconductor device, this is merely an example. As another example, the semiconductor device may include a tunneling transistor (FET), a vertical FET (VFET), a complementary FET (CFET), or a three-dimensional (3D) transistor. Alternatively, the semiconductor device may include a bipolar junction transistor, a lateral double-diffused transistor (LDMOS), or the like.

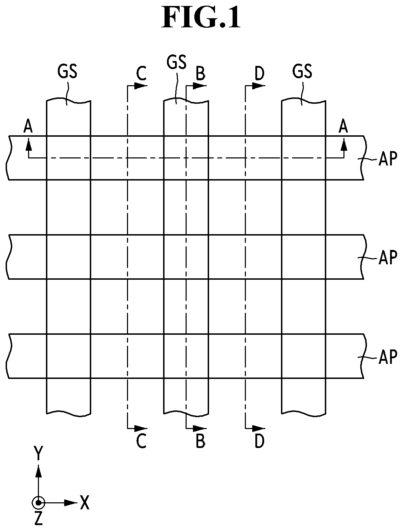

Hereinafter, a semiconductor device according to example embodiments will be described referring to FIGS. 1 to 14.

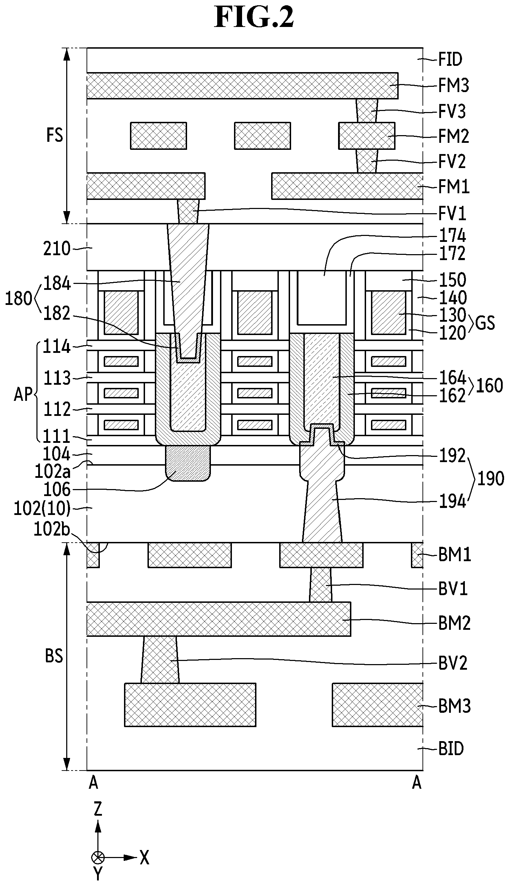

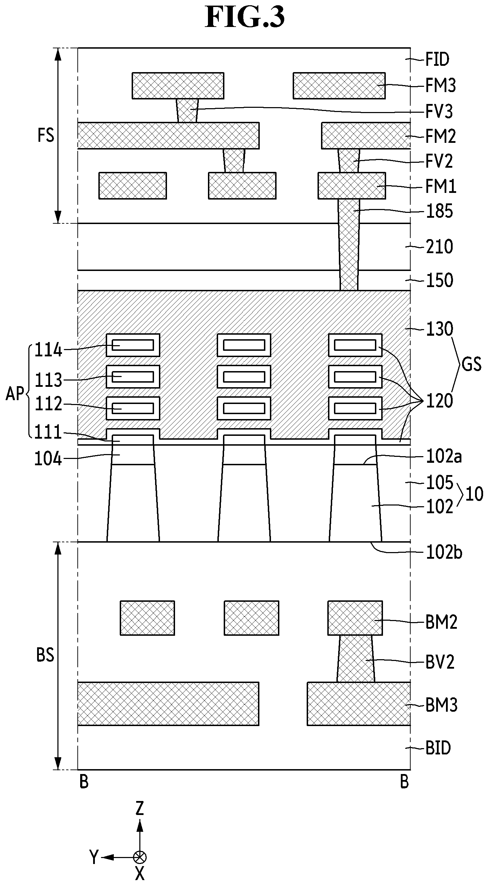

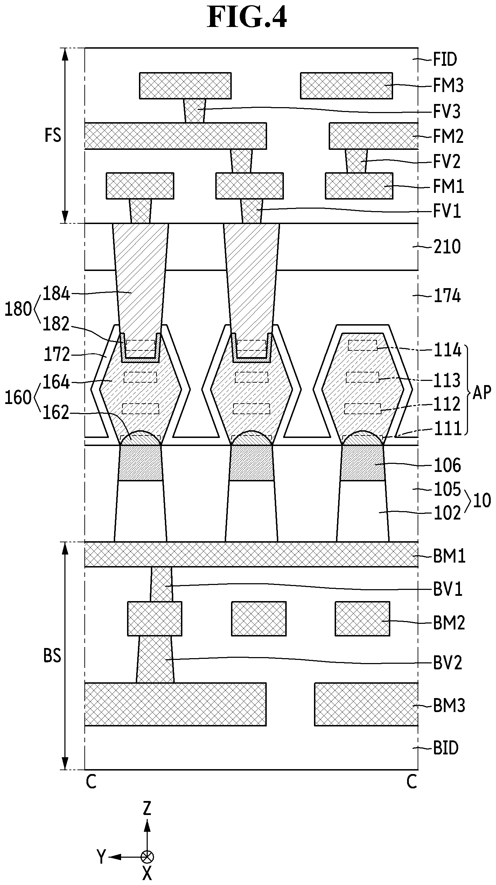

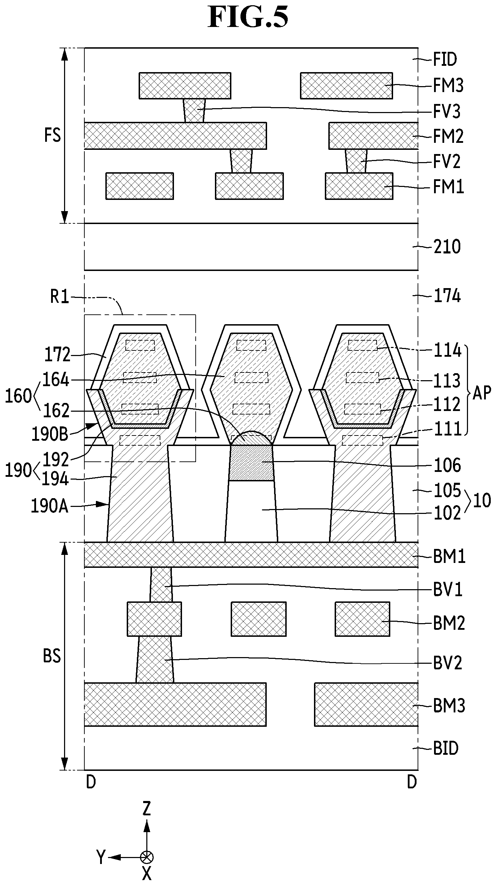

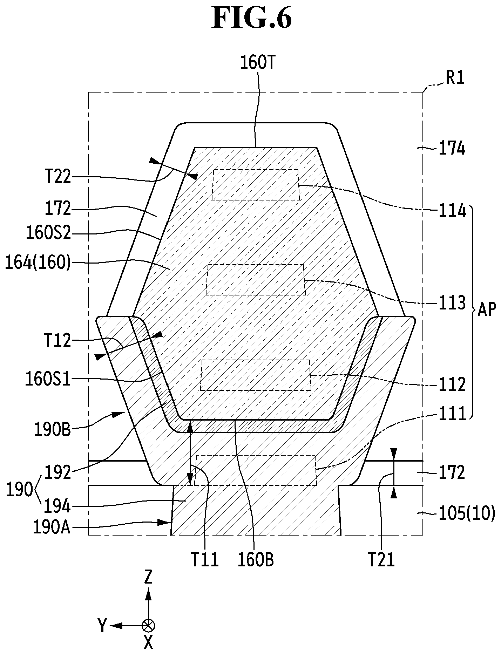

FIG. 1 is an example layout diagram for explaining a semiconductor device according to one or more embodiments. FIG. 2 is a schematic cross-sectional view taken along A-A of FIG. 1. FIG. 3 is a schematic cross-sectional view taken along B-B of FIG. 1. FIG. 4 is a schematic cross-sectional view taken along C-C of FIG. 1. FIG. 5 is a schematic cross-sectional view taken along D-D of FIG. 1. FIG. 6 is an enlarged view for explaining a region R1 of FIG. 5.

Referring to FIGS. 1 to 6, the semiconductor device according to one or more embodiments includes a substrate 10, an active pattern AP, a gate structure GS, a gate spacer 140, a gate capping film 150, a source/drain pattern 160, an etch stop layer 172, a first interlayer insulating film 174, a second interlayer insulating film 210, a front side source/drain contact 180, a front side wiring structure FS, a back side source/drain contact 190, and a back side wiring structure BS.

The substrate 10 may include an upper side and a lower side that are opposite to each other. In this specification, the upper side of the substrate 10 may also be referred to as a front (or first) side of the substrate 10, and the lower side of the substrate 10 may also be referred to as a back (or second) side of the substrate 10.

In one or more embodiments, the substrate 10 may include an insulating material. For example, the substrate 10 may be an insulating substrate including at least one of silicon oxide, silicon oxynitride, silicon oxycarbonitride or a combination thereof.

In one or more embodiments, the substrate 10 may include a plurality of base patterns 102 and a field insulating film 105.

The base patterns 102 may be spaced apart from each other and extend side by side. For example, the base patterns 102 may each extend long in a first direction X, and may be spaced apart from each other in a second direction Y intersecting the first direction X. In one or more embodiments, each base pattern 102 may include an insulating material. For example, each base pattern 102 may include at least one of silicon oxide, silicon nitride, silicon oxycarbide, silicon oxynitride, silicon oxycarbonitride or a combination thereof, but the disclosure is not limited thereto.

Each base pattern 102 may include a first face 102a and a second face 102b that are opposite to each other. The first face 102a may be included on the front side of the substrate 10, and the second face 102b may be included on the back side of the substrate 10.

The field insulating film 105 may cover at least a part of the side faces of each base pattern 102. For example, the field insulating film 105 may fill a space between the base patterns 102 spaced apart along the second direction Y. The field insulating film 105 may include, for example at least one of silicon oxide, silicon nitride, silicon oxycarbide, silicon oxynitride, silicon oxycarbonitride, and combinations thereof, but the disclosure is not limited thereto.

In one or more embodiments, the lower face of the field insulating film 105 may be coplanar with the second face 102b of each of base patterns 102. In FIGS. 3 to 5, the upper face of the field insulating film 105 is shown to be higher than the first face 102a of each base pattern 102, but this is only an example. The upper face of the field insulating film 105 may be coplanar with the first face 102a or may be lower than the first face 102a.

In addition, although a boundary between the base patterns 102 and the field insulating film 105 is shown to exist, this is only an example. For example, if the base patterns 102 and the field insulating film 105 include the same material, there may be no boundary between the base patterns 102 and the field insulating film 105.

The active pattern AP may be formed on the upper side of the substrate 10. The active pattern AP may extend long in the first direction X. The plurality of active patterns AP may extend side by side in the first direction X.

In one or more embodiments, the active pattern AP may include a plurality of bridge patterns (e.g., first to fourth bridge patterns 111 to 114) stacked in sequence on the first face 102a and spaced apart from one another. The first to fourth bridge patterns 111 to 114 may be spaced apart from one another in a third direction Z that intersects the first direction X and the second direction Y. Such an active pattern AP may be used as a channel region of an MBCFET^{®} including a multi-bridge channel. The number of bridge patterns included in the active pattern AP is only an example, and the disclosure is not limited to those embodiments shown.

The active pattern AP may include silicon (Si) or germanium (Ge), which are elemental semiconductor materials. As an example, the active pattern AP may include a silicon pattern. Alternatively, the active pattern AP may include a compound semiconductor, for example, a group IV-IV compound semiconductor or a group III-V compound semiconductor. The group IV-IV compound semiconductor may be, for example, a binary compound, a ternary compound including at least two or more of carbon (C), silicon (Si), germanium (Ge), and tin (Sn), or a compound obtained by doping these elements with a group IV element. The III-V compound semiconductor may be, for example, one of a binary compound, a ternary compound or a quaternary compound formed by combining at least one of aluminum (Al), gallium (Ga), and indium (In), which are group III elements, with at least one of phosphorus (P), arsenic (As) and antimony (Sb), which are group V elements.

In one or more embodiments, a buffer pattern 104 may be formed between the substrate 10 and the active pattern AP. The buffer pattern 104 may extend in the first direction X along the first face 102a. The first to fourth bridge patterns 111 to 114 may be sequentially disposed on an upper face of the buffer pattern 104. In FIG. 3, although the upper face of the field insulating film 105 is shown as being coplanar with the upper face of the buffer pattern 104, this is merely an example. The upper face of the field insulating film 105 may be lower than the upper face of the buffer pattern 104.

The buffer pattern 104 may include a semiconductor material. For example, the buffer pattern 104 may include a silicon germanium (SiGe) layer. In one or more embodiments, the buffer pattern 104 may further include a high concentration of impurities. Such a buffer pattern 104 may prevent a punch-through phenomenon in the buffer pattern 104. As an example, if a field effect transistor formed on the buffer pattern 104 is an NFET, the buffer pattern 104 may include a high concentration of p-type impurities. The p-type impurities may include, for example, at least one of B, C, In, Ga, Al, and combinations thereof. As another example, if the field effect transistor on the buffer pattern 104 is a PFET, the buffer pattern 104 may include a high concentration of n-type impurities. The n-type impurities may include, for example, at least one of P, Sb, As, and combinations thereof.

The gate structure GS may be formed on the substrate 10 and the active pattern AP. The gate structure GS may intersect the active pattern AP. For example, the gate structure GS may extend long in the second direction Y. A plurality of gate structures GS may extend side by side in the second direction Y.

In one or more embodiments, the active pattern AP may extend in the first direction X and penetrate the gate structure GS. For example, each of the first to fourth bridge patterns 111 to 114 may extend in the first direction X and penetrate the gate structure GS. The gate structure GS may surround the periphery of each of the first to fourth bridge patterns 111 to 114.

The gate structure GS may include a gate dielectric film 120 and a gate electrode 130. The gate dielectric film 120 and the gate electrode 130 may be sequentially stacked on the active pattern AP.

The gate dielectric film 120 may be formed on the active pattern AP. For example, the gate dielectric film 120 may conformally extend along the periphery of each of the first to fourth bridge patterns 111 to 114. The gate dielectric film 120 may further extend along the upper face of the field insulating film 105.

The gate dielectric film 120 may include, for example, at least one of silicon oxide, silicon oxynitride, silicon nitride or a high dielectric constant material having a dielectric constant greater than that of silicon oxide. The high dielectric constant material may include, for example, at least one of hafnium oxide (HfO₂), zirconium oxide (ZrO₂), lanthanum oxide (La₂O₃), aluminum oxide (Al₂O₃), titanium oxide (TiO₂), strontium titanium oxide (SrTiO₃), lanthanum aluminum oxide (LaAlO₃), yttrium oxide (Y₂O₃), hafnium oxynitride (HfOₓN_{y}), zirconium oxynitride (ZrOₓN_{y}), lanthanum oxynitride (La₂OₓN_{y}), aluminum oxynitride (Al₂OₓN_{y}), titanium oxynitride (TiOₓN_{y}), strontium titanium oxynitride (SrTiOₓN_{y}), lanthanum aluminum oxynitride (LaAlOₓN_{y}), yttrium oxynitride (Y₂OₓN_{y}), or combinations thereof, but the disclosure is not limited thereto.

The semiconductor device according to one or more embodiments may include an NC (Negative Capacitance) FET that uses a negative capacitor. For example, the gate dielectric film 120 may include a ferroelectric material film having ferroelectric properties, and a paraelectric material film having paraelectric properties.

The ferroelectric material film may have a negative capacitance, and the paraelectric material film may have a positive capacitance. For example, if two or more capacitors are connected in series and the capacitance of each capacitor has a positive value, the overall capacitances decrease from the capacitance of each of the individual capacitors. On the other hand, if at least one of the capacitances of two or more capacitors connected in series has a negative value, the overall capacitance may be greater than an absolute value of each of the individual capacitances, while having a positive value.

When the ferroelectric material film having the negative capacitance and the paraelectric material film having the positive capacitance are connected in series, the overall capacitance values of the ferroelectric material film and the paraelectric material film connected in series may increase. By increasing overall capacitance values, a transistor including the ferroelectric material film may have a subthreshold swing (SS) below 60 mV/decade at room temperature.

The ferroelectric material film may have ferroelectric properties. The ferroelectric material film may include, for example, at least one of hafnium oxide, hafnium zirconium oxide, barium strontium titanium oxide, barium titanium oxide, or lead zirconium titanium oxide. Here, as an example, the hafnium zirconium oxide may be a material obtained by doping hafnium oxide with zirconium (Zr). As another example, the hafnium zirconium oxide may be a compound of hafnium (Hf), zirconium (Zr), and oxygen (O).

The ferroelectric material film may further include a doped dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), or tin (Sn). The type of dopant included in the ferroelectric material film may vary depending on which ferroelectric material is included in the ferroelectric material film.

When the ferroelectric material film includes hafnium oxide, the dopant included in the ferroelectric material film may include, for example, at least one of gadolinium (Gd), silicon (Si), zirconium (Zr), aluminum (Al), or yttrium (Y).

When the dopant is aluminum (Al), the ferroelectric material film may include 3 at% to 8 at% (atomic %) aluminum. Here, a ratio of the dopant may be a ratio of aluminum to the sum of hafnium and aluminum.

When the dopant is silicon (Si), the ferroelectric material film may include 2 at% to 10 at% silicon. When the dopant is yttrium (Y), the ferroelectric material film may include 2 at% to 10 at% yttrium. When the dopant is gadolinium (Gd), the ferroelectric material film may include 1 at% to 7 at% gadolinium. When the dopant is zirconium (Zr), the ferroelectric material film may include 50 at% to 80 at% zirconium.

The paraelectric material film may have paraelectric properties. The paraelectric material film may include at least one of, for example, a silicon oxide and a metal oxide having a high dielectric constant. The metal oxide included in the paraelectric material film may include, for example, at least one of hafnium oxide, zirconium oxide, and aluminum oxide, but the disclosure is not limited thereto.

The ferroelectric material film and the paraelectric material film may include the same material. The ferroelectric material film has the ferroelectric properties, but the paraelectric material film may not have the ferroelectric properties. For example, when the ferroelectric material film and the paraelectric material film include hafnium oxide, a crystal structure of hafnium oxide included in the ferroelectric material film is different from a crystal structure of hafnium oxide included in the paraelectric material film.

The ferroelectric material film may have a thickness having the ferroelectric properties. The thickness of the ferroelectric material film may be, for example, 0.5 to 10 nm, but the disclosure is not limited thereto. Since a critical thickness that exhibits the ferroelectric properties may differ for each ferroelectric material, the thickness of the ferroelectric material film may vary depending on the ferroelectric material.

As an example, the gate dielectric film 120 may include one ferroelectric material film. As another example, the gate dielectric film 120 may include a plurality of ferroelectric material films spaced apart from one another. The gate dielectric film 120 may have a stacked layer structure in which a plurality of ferroelectric material films and a plurality of paraelectric material films are alternately stacked.

The gate electrode 130 may be stacked on the gate dielectric film 120. The gate dielectric film 120 may be interposed between the active pattern AP and the gate electrode 130. The gate electrode 130 may be formed by, for example, a replacement process, but the disclosure is not limited thereto.

Although the gate electrode 130 is shown as being a single film, this is an example only, and the gate electrode 130 may be formed by stacking the plurality of conductive films. For example, the gate electrode 130 may include a work function adjusting film that adjusts a work function, and a filling conductive film that fills a space formed by the work function adjusting film. The work function adjusting film may include, for example at least one of TiN, TaN, TiC, TaC, TiAlC, and combinations thereof, but the disclosure is not limited thereto. The filling conductive film may include, for example W or Al, but the disclosure is not limited thereto.

A gate spacer 140 may extend along the side faces of the gate electrode 130 in the second direction Y. In one or more embodiments, a part of the gate dielectric film 120 may be interposed between the gate electrode 130 and the gate spacer 140. For example, the gate dielectric film 120 may further extend along an inner side face of the gate spacer 140. The gate dielectric film 120 may be formed by a replacement process, but the disclosure is not limited thereto.

The gate spacer 140 may include an insulating material, for example at least one of silicon nitride, silicon oxynitride, silicon oxycarbide, silicon boron nitride, silicon boron carbonitride, silicon oxycarbonitride, and combinations thereof, but the disclosure is not limited thereto. As an example, the gate spacer 140 may include a silicon nitride film.

The gate capping film 150 may extend along the upper face of the gate structure GS in the second direction Y. Although the upper face of the gate capping film 150 is shown as being coplanar with the upper face of the gate spacer 140, this is merely an example. As another example, the gate capping film 150 may cover the upper face of the gate spacer 140.

The gate capping film 150 may include an insulating material, for example at least one of silicon nitride, silicon oxynitride, silicon oxycarbide, silicon boron nitride, silicon boron carbonitride, silicon oxycarbonitride, and combinations thereof, but the disclosure is not limited thereto. As an example, the gate capping film 150 may include a silicon nitride film.

The source/drain pattern 160 may be formed on at least one side face (e.g., both side faces) of the gate structure GS. Also, the source/drain pattern 160 may be connected to the active pattern AP. For example, each of the first to fourth bridge patterns 111 to 114 may penetrate the gate structure GS and be connected to the source/drain pattern 160. The source/drain pattern 160 may be separated from the gate electrode 130 by the gate dielectric film 120 and/or the gate spacer 140. The source/drain pattern 160 may be provided as a source/drain region of a field effect transistor including the active pattern AP and the gate structure GS.

In one or more embodiments, the source/drain pattern 160 may include an epitaxial layer. For example, the source/drain pattern 160 may be an epitaxial pattern formed by an epitaxial growth process. As shown in FIGS. 4 and 5, the cross-section of the source/drain pattern 160 intersecting the first direction X may be pentagonal, but this is merely an example. The cross-section of the source/drain pattern 160 intersecting the first direction X may have various shapes such as a hexagonal shape or a diamond shape, depending on the epitaxial growth conditions.

In one or more embodiments, as shown in FIG. 6, the cross-section of the source/drain pattern 160 intersecting the first direction X may include a first side face 160S1 and a second side face 160S2. The first side face 160S1 may extend from the lower face 160B of the source/drain pattern 160. The first side face 160S1 may form an obtuse angle with the lower face 160B of the source/drain pattern 160. That is, an interior angle formed between the lower face 160B of the source/drain pattern 160 and the first side face 160S1 may be greater than 90°. The second side face 160S2 may extend from the upper face 160T of the source/drain pattern 160. The second side face 160S2 may form an obtuse angle with the upper face 160T of the source/drain pattern 160. That is, the interior angle formed between the upper face 160T of the source/drain pattern 160 and the second side face 160S2 may be greater than 90°.

When the source/drain pattern 160 is provided as a source/drain region of an NFET, the source/drain pattern 160 may include n-type impurities or impurities for preventing the diffusion of n-type impurities. For example, the source/drain pattern 160 may include at least one of P, Sb, As, and combinations thereof.

In one or more embodiments, the source/drain pattern 160 may include a tensile stress material. As an example, when the active pattern AP is a silicon (Si) pattern, the source/drain pattern 160 may include a material having a smaller lattice constant (e.g., silicon carbide (SiC)) than silicon (Si). The tensile stress material may apply a tensile stress to the active pattern AP to improve the carrier mobility of the channel region.

When the source/drain pattern 160 is provided as a source/drain region of a PFET, the source/drain pattern 160 may include p-type impurities or impurities for preventing the diffusion of the p-type impurities. For example, the source/drain pattern 160 may include at least one of B, C, In, Ga, Al, and combinations thereof.

In one or more embodiments, the source/drain pattern 160 may include a compressive stress material. As an example, when the active pattern AP is a silicon pattern, the source/drain pattern 160 may include a material having a larger lattice constant (e.g., silicon germanium (SiGe)) than silicon Si. The compressive stress material may apply a compressive stress to the active pattern AP and thereby improve the carrier mobility of the channel region.

In one or more embodiments, a holder pattern 106 may be formed between the substrate 10 and the source/drain pattern 160. The holder pattern 106 may overlap the source/drain pattern 160 in the third direction Z. A lower face of the holder pattern 106 may be lower than a lower face of the buffer pattern 104. For example, as shown in FIG. 2, the lower part of the holder pattern 106 may protrude toward the base pattern 102 beyond the lower face of the buffer pattern 104. In FIGS. 4 and 5, although the upper face of the field insulating film 105 is shown as being coplanar with the upper face of the holder pattern 106, this is merely an example. The upper face of the field insulating film 105 may be lower than the upper face of the holder pattern 106.

The holder pattern 106 may include a semiconductor material. For example, the holder pattern 106 may include a silicon germanium (SiGe) layer. In one or more embodiments, the source/drain pattern 160 may be formed by an epitaxial growth process that uses the active pattern AP and the holder pattern 106 as seed layers.

In one or more embodiments, the source/drain pattern 160 may include a first epitaxial layer 162 and a second epitaxial layer 164. The first epitaxial layer 162 and the second epitaxial layer 164 may be sequentially stacked on the holder pattern 106 and the active pattern AP. For example, the first epitaxial layer 162 may extend along the upper face of the holder pattern 106, the side face of the gate spacer 140, and the side faces of each of the first to fourth bridge patterns 111 to 114. The second epitaxial layer 164 may be stacked on the first epitaxial layer 162. The first epitaxial layer 162 may be provided as a seed layer for growing the second epitaxial layer 164.

The impurity concentration of the second epitaxial layer 164 may be greater than the impurity concentration of the first epitaxial layer 162. As an example, when the source/drain pattern 160 is provided as a source/drain region of an NFET, the n-type impurity concentration of the second epitaxial layer 164 may be greater than the n-type impurity concentration of the first epitaxial layer 162. As another example, when the source/drain pattern 160 is provided as a source/drain region of a PFET, the p-type impurity concentration of the second epitaxial layer 164 may be greater than the p-type impurity concentration of the first epitaxial layer 162.

The etch stop layer 172 may be formed on the substrate 10, the gate structure GS, and the source/drain pattern 160. For example, the etch stop layer 172 may conformally extend along the profile of the upper face of the field insulating film 105, the side face of the gate spacer 140, and the outer face of the source/drain pattern 160.

The first interlayer insulating film 174 may be formed on the etch stop layer 172. The first interlayer insulating film 174 may be formed to fill a space above the etch stop layer 172. The second interlayer insulating film 210 may be formed on the first interlayer insulating film 174. The second interlayer insulating film 210 may be formed to cover the first interlayer insulating film 174 and the gate capping film 150.

The first interlayer insulating film 174 and the second interlayer insulating film 210 may each include, for example, at least one of silicon oxide, silicon nitride, silicon oxynitride, silicon oxycarbide, silicon boron nitride, silicon boron carbonitride, silicon oxycarbonitride, and a low dielectric constant material having a lower dielectric constant than silicon oxide. The low dielectric constant material may include, for example at least one of FOX (Flowable Oxide), TOSZ (Torene SilaZene), USG (Undoped Silica Glass), BSG (Borosilica Glass), PSG (PhosphoSilica Glass), BPSG (BoroPhosphoSilica Glass), PETEOS (Plasma Enhanced Tetra Ethyl Ortho Silicate), FSG (Fluoride Silicate Glass), CDO (Carbon Doped silicon Oxide), Xerogel, Aerogel, Amorphous Fluorinated Carbon, OSG (Organo Silicate Glass), Parylene, BCB (bis-benzocyclobutenes), SiLK, polyimide, porous polymeric material, and combinations thereof, but the disclosure is not limited thereto.

The first interlayer insulating film 174 and the second interlayer insulating film 210 may have an etching selectivity relative to the etch stop layer 172. As an example, when the first interlayer insulating film 174 and the second interlayer insulating film 210 each include a silicon oxide film, the etch stop layer 172 may include at least one of silicon nitride (SiN), silicon oxynitride (SiON), silicon oxycarbonitride (SiOCN), silicon boron nitride (SiBN), silicon oxyboronitride (SiOBN), silicon oxycarbide (SiOC), and combinations thereof. The etch stop layer 172 may be provided as an etch stop layer in an etching process for forming the front side source/drain contact 180.

The front side source/drain contact 180 may be formed on the source/drain pattern 160. The front side source/drain contact 180 may extend in the third direction Z, and be connected to the source/drain pattern 160. For example, the front side source/drain contact 180 sequentially penetrates the second interlayer insulating film 210, the first interlayer insulating film 174, and the etch stop layer 172, and may come into direct contact with the upper part of the source/drain pattern 160.

A width of the front side source/drain contact 180 may decrease toward the source/drain pattern 160. Here, the width refers to a width in a plane (e.g., an XY plane) intersecting the third direction Z. The etching process for forming the front side source/drain contact 180 may be performed toward the upper face of the source/drain pattern 160.

In one or more embodiments, the front side source/drain contact 180 may include a first silicide film 182 and a first metal film 184 that are sequentially stacked on the source/drain pattern 160.

The first metal film 184 may include, a conductive material, for example a metal material, such as cobalt (Co), titanium (Ti), tantalum (Ta), ruthenium (Ru), tungsten (W) or cobalt tungsten phosphide (CoWP), but the disclosure is not limited thereto.

The first silicide film 182 may be interposed between the source/drain pattern 160 and the first metal film 184. The first silicide film 182 may be formed by reacting silicon (Si) contained in the source/drain pattern 160 with a metal element (e.g., a metal element contained in the first metal film 184). The first silicide film 182 may include, for example a metal silicide such as nickel silicide, cobalt silicide, tungsten silicide, titanium silicide, niobium silicide or tantalum silicide, but the disclosure is not limited thereto.

The front side wiring structure FS may be formed on the upper face of the second interlayer insulating film 210. The front side wiring structure FS may include a front inter-wiring insulating film FID, multi-layered front wiring patterns FM1 to FM3 inside the front inter-wiring insulating film FID, and front via patterns FV1 to FV3 that interconnect the front wiring patterns FM1 to FM3. The number of layers, the number of the front wiring patterns (FM1 to FM3), and the placement of the front inter-wiring insulating film FID, and the number of front via patterns (FV1 to FV3) are merely an example, and the disclosure is not limited thereto.

The front side wiring structure FS may provide a signal line and/or a power line for various electronic elements (e.g., a field effect transistor including an active pattern AP and a gate structure GS) formed on the front side of the substrate 10. For example, the first front via pattern FV1 of the front side wiring structure FS may be connected to the front side source/drain contact 180. Accordingly, the front side wiring structure FS may be electrically connected to the source/drain pattern 160.

In one or more embodiments, a gate contact 185 may be formed on the gate structure GS. The gate contact 185 sequentially penetrates the second interlayer insulating film 210, the first interlayer insulating film 174, and the gate capping film 150, and may be connected to the gate electrode 130. The gate contact 185 may connect the gate electrode 130 and the first front wiring pattern FM1. Accordingly, the front side wiring structure FS may be electrically connected to the gate electrode 130. In one or more embodiments, the gate contact 185 may connect the gate electrode 130 and the first front via pattern FV1.

The front wiring patterns FM1 to FM3 and the front via patterns FV1 to FV3 may each include a barrier conductive film and a filling conductive film. The barrier conductive film may include a metal or a metal nitride for preventing diffusion of the filling conductive film. Although the barrier conductive film may include, for example at least one of titanium (Ti), tantalum (Ta), tungsten (W), nickel (Ni), cobalt (Co), platinum (Pt), alloys thereof, or nitrides thereof, the disclosure is not limited thereto. The filling conductive film may include, for example at least one of aluminum (Al), copper (Cu), tungsten (W), molybdenum (Mo), cobalt (Co), ruthenium (Ru), or alloys thereof, but the disclosure is not limited thereto.

The back side source/drain contact 190 may be formed under the source/drain pattern 160. The back side source/drain contact 190 may extend in the third direction Z and be connected to the source/drain pattern 160. For example, the back side source/drain contact 190 may penetrate the substrate 10 and come into direct contact with the lower part of the source/drain pattern 160.

The back side source/drain contact 190 may extend along at least a part of the side face of the source/drain pattern 160 that intersects the second direction Y. The uppermost part of the back side source/drain contact 190 may come into contact with the etch stop layer 172. Specifically, the back side source/drain contact 190 may include a first pillar part 190A and a first wrapping part 190B.

The first pillar part 190A may penetrate the substrate 10 and come into contact with the lower face 160B of the source/drain pattern 160. A width of the first pillar part 190A may decrease toward the source/drain pattern 160. Here, the width refers to a width in a plane intersecting the third direction Z (e.g., an XY plane). Although the width of the first pillar part 190A is shown to be larger than the width of the base pattern 102, this is merely an example. The width of the first pillar part 190A may be smaller than the width of the base pattern 102.

In FIGS. 5 and 6, the upper face of the first pillar part 190A that comes into contact with the lower face 160B of the source/drain pattern 160 is shown to be higher than the uppermost part of the first epitaxial layer 162, but this is merely an example. The upper face of the first pillar part 190A may be coplanar with the uppermost part of the first epitaxial layer 162, or may be lower than the uppermost part of the first epitaxial layer 162. Alternatively, when the upper face of the first pillar part 190A is formed to be lower than the uppermost part of the first epitaxial layer 162, a part of the first epitaxial layer 162 may be interposed between the first pillar part 190A and the second epitaxial layer 164.

In one or more embodiments, a distance T11 from the upper face of the field insulating film 105 to the upper face of the first pillar part 190A may be greater than a thickness T21 of the etch stop layer 172 extending along the upper face of the field insulating film 105.

The first wrapping part 190B may extend from the first pillar part 190A. The first wrapping part 190B may protrude upward beyond the upper face of the first pillar part 190A. The first wrapping part 190B may extend along at least a part of a side face of the source/drain pattern 160 that intersects the second direction Y. The first wrapping part 190B may come into contact with at least a part of a side face of the source/drain pattern 160 that intersects the second direction Y.

The upper face of the first wrapping part 190B may come into contact with the etch stop layer 172. For example, the first wrapping part 190B may extend along a part of the side face of the source/drain pattern 160, and the etch stop layer 172 may extend from the upper face of the first wrapping part 190B along another part of the side face of the source/drain pattern 160.

In one or more embodiments, the first wrapping part 190B may come into contact with at least a part of the side face of the second epitaxial layer 164. For example, the first epitaxial layer 162 may not be interposed between the first wrapping part 190B and the second epitaxial layer 164.

In one or more embodiments, a thickness T12 of the first wrapping part 190B may be greater than a thickness T22 of the etch stop layer 172. For example, as shown in FIG. 6, a part of the first wrapping part 190B may protrude beyond the etch stop layer 172 toward the source/drain pattern 160. Alternatively, for example, as shown in FIG. 6, a part of the first wrapping part 190B may protrude beyond the etch stop layer 172 toward the first interlayer insulating film 174.

In one or more embodiments, the thickness T12 of the first wrapping part 190B may be smaller than the distance T11 from the upper face of the field insulating film 105 to the upper face of the first pillar part 190A.

In one or more embodiments, as shown in FIG. 6, the first wrapping part 190B may extend along the first side face 160S1 of the source/drain pattern 160. The first wrapping part 190B may not extend along the second side face 160S2 of the source/drain pattern 160. For example, the first wrapping part 190B may come into contact with the first side face 160S1 of the source/drain pattern 160, and the etch stop layer 172 may come into contact with the upper face 160T and the second side face 160S2 of the source/drain pattern 160.

In one or more embodiments, the back side source/drain contact 190 may include a second silicide film 192 and a second metal film 194 that are sequentially stacked on the source/drain pattern 160.

The second metal film 194 may include a conductive material, for example, cobalt (Co), titanium (Ti), tantalum (Ta), ruthenium (Ru), tungsten (W) or cobalt tungsten phosphide (CoWP), but the disclosure is not limited thereto.

The second silicide film 192 may be interposed between the second epitaxial layer 164 included in the source/drain pattern 160 and the second metal film 194. The second silicide film 192 may be formed by reacting silicon (Si) contained in the source/drain pattern 160 with a metal element (e.g., a metal element contained in the second metal film 194). The second silicide film 192 may include, for example, a metal silicide, such as nickel silicide, cobalt silicide, tungsten silicide, titanium silicide, niobium silicide or tantalum silicide, but the disclosure is not limited thereto.

In one or more embodiments, the second silicide film 192 may extend along the lower face 160B and the first side face 160S1 of the source/drain pattern 160.

The back side wiring structure BS may be formed on the lower side of the substrate 10. The back side wiring structure BS may include a back side inter-wiring insulating film BID, multi-layered back side wiring patterns BM1 to BM3 inside the back side inter-wiring insulating film BID, and a back side via patterns BV1 and BV2 that interconnect the back side wiring patterns BM1 to BM3. The number of layers, and the number and placement of the back side inter-wiring insulating film BID, the back side wiring patterns BM1 to BM3 and the back side via patterns BV1 and BV2, are merely examples, and the disclosure is not limited thereto.

The back side wiring structure BS may provide a power distribution network (PDN) on the back side of the substrate 10 for various electronic elements formed on the front side of the substrate 10. For example, the first back side wiring pattern BM1 of the back side wiring structure BS may be connected to the back side source/drain contact 190. A power supply voltage (e.g., source voltage V_{SS} or drain voltage V_{DD}) supplied from the outside may be provided to the source/drain pattern 160 through the back side wiring patterns BM1 to BM3, the back side via patterns BV1 and BV2, and the back side source/drain contact 190.

The back side wiring patterns BM1 to BM3 and the back side via patterns BV1 and BV2 may each include a barrier conductive film and a filling conductive film. The barrier conductive film may include a metal or a metal nitride for preventing the diffusion of the filling conductive film. The barrier conductive film may include at least one of, for example titanium (Ti), tantalum (Ta), tungsten (W), nickel (Ni), cobalt (Co), platinum (Pt), alloys thereof, or nitrides thereof, but the disclosure is not limited thereto. The filling conductive film may include, for example at least one of aluminum (Al), copper (Cu), tungsten (W), molybdenum (Mo), cobalt (Co), ruthenium (Ru), or alloys thereof, but the disclosure is not limited thereto.

The semiconductor device according to one or more embodiments may have a reduced voltage drop by providing a so-called back side power distribution network (BSPDN). For example, as described above, the back side wiring structure BS that provides the power distribution network (PDN) may be disposed on the lower side (or back side) of the substrate 10 on which the integrated circuit (e.g., field effect transistor) is not disposed. Accordingly, the semiconductor device according to one or more embodiments can improve voltage drop by minimizing the crosstalk of the routing while reducing size as compared to a design where the power distribution network (PDN) is disposed on the upper side (or front side) of the substrate 10.

A contact (hereinafter, back side direct contact) that directly connects the back side power distribution network (BSPDN) to the source/drain region is provided for connecting the back side power distribution network (BSPDN) and the integrated circuit. The back side direct contact is advantageous in terms of PPAC (Power, Performance, Area, and Cost) characteristics because it may connect the back side power distribution network (BSPDN) to the integrated circuit via the shortest path.

However, since such a back side direct contact is formed from the lower part of the source/drain region, there is a problem that the contact resistance with the source/drain region is high. For example, the source/drain region may include a lower epitaxial layer (e.g., the first epitaxial layer 162) containing a low concentration of impurities and an upper epitaxial layer (e.g., the second epitaxial layer 164) containing a high concentration of impurities. The back side direct contact has a relatively large area that comes into contact with the lower epitaxial layer, and may form a high contact resistance with the source/drain region.

In contrast, the semiconductor device according to one or more embodiments has a reduced contact resistance, using a back side source/drain contact 190 equipped with the first wrapping part 190B. Specifically, as described above, the first wrapping part 190B of the back side source/drain contact 190 protrudes beyond the upper face of the first pillar part 190A and may come into contact with at least a part of the side face of the source/drain pattern 160. Such a first wrapping part 190B has a relatively large area that comes into contact with the second epitaxial layer 164, and may form a low contact resistance with the source/drain pattern 160. Accordingly, a semiconductor device having further improved PPAC characteristics can be provided.

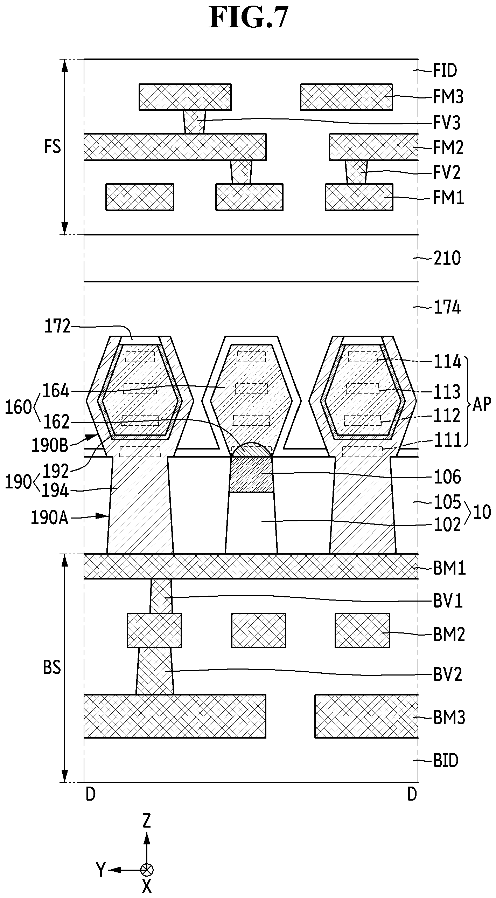

FIGS. 7 to 16 are various diagrams for explaining a semiconductor device according to one or more embodiments. For convenience of explanation, repeated parts of contents explained above using FIGS. 1 to 6 will be briefly explained or omitted.

Referring to FIG. 7, in the semiconductor device according to one or more embodiments, the back side source/drain contact 190 may completely cover the side face of the source/drain pattern 160 that intersects the second direction Y. For reference, FIG. 7 is another schematic cross-sectional view taken along D-D of FIG. 1.

For example, the first wrapping part 190B may extend along the first side face (160S1 of FIG. 6) and the second side face (160S2 of FIG. 6) of the source/drain pattern 160. The first wrapping part 190B may come into contact with the first side face (160S1 of FIG. 6) and the second side face (160S2 of FIG. 6) of the source/drain pattern 160, and the etch stop layer 172 may come into contact with the upper face (160T of FIG. 6) of the source/drain pattern 160.

In one or more embodiments, the second silicide film 192 may extend along the lower face (160B of FIG. 6), the first side face (160S1 of FIG. 6) and the second side face (160S2 of FIG. 6) of the source/drain pattern 160.

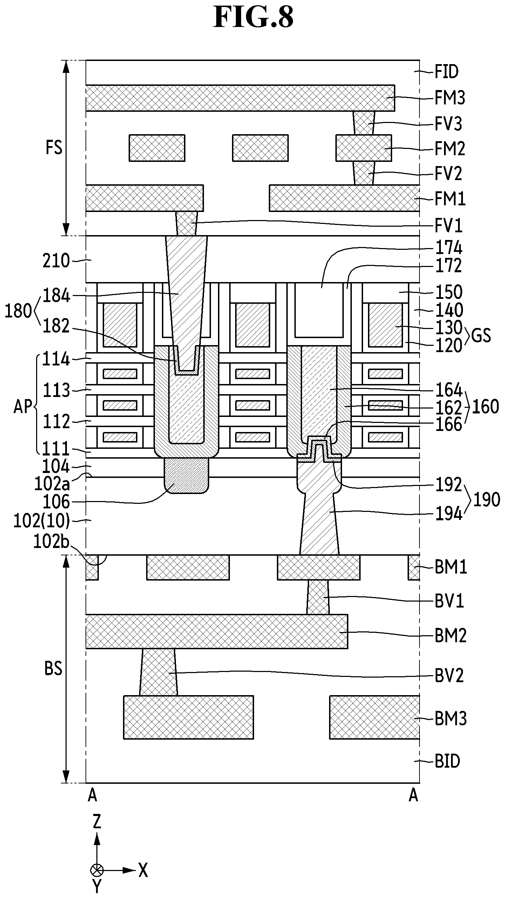

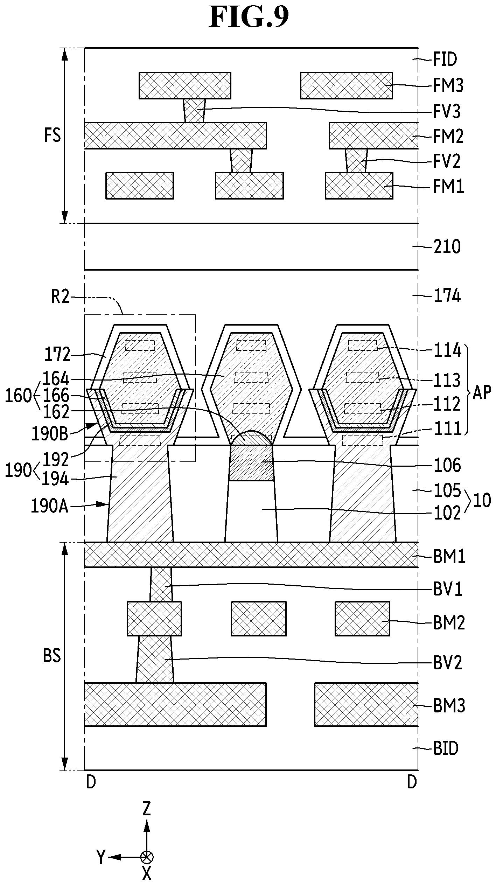

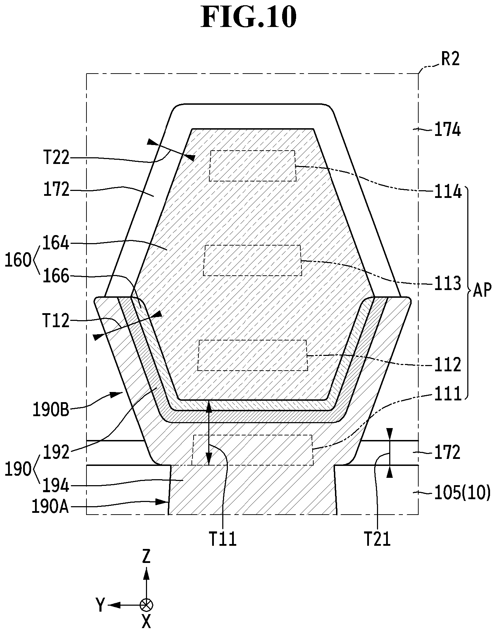

Referring to FIGS. 8 to 10, in the semiconductor device according to one or more embodiments, the source/drain pattern 160 further includes a third epitaxial layer 166. For reference, FIG. 8 is another schematic cross-sectional view taken along A-A of FIG. 1, FIG. 9 is another schematic cross-sectional view taken along D-D of FIG. 1, and FIG. 10 is an enlarged view for explaining the region R2 of FIG. 9.

The third epitaxial layer 166 may be interposed between the first epitaxial layer 162 and the back side source/drain contact 190, and between the second epitaxial layer 164 and the back side source/drain contact 190. The back side source/drain contact 190 may come into contact with the third epitaxial layer 166. The third epitaxial layer 166 may be formed by an epitaxial growth process that uses the first epitaxial layer 162 and the second epitaxial layer 164 as seed layers.

In one or more embodiments, the impurity concentration of the third epitaxial layer 166 may be greater than the impurity concentration of the first epitaxial layer 162. As an example, when the source/drain pattern 160 is provided as a source/drain region of an NFET, the n-type impurity concentration of the third epitaxial layer 166 is greater than the n-type impurity concentration of the first epitaxial layer 162. As another example, when the source/drain pattern 160 is provided as a source/drain region of a PFET, the p-type impurity concentration of the third epitaxial layer 166 may be greater than the p-type impurity concentration of the first epitaxial layer 162.

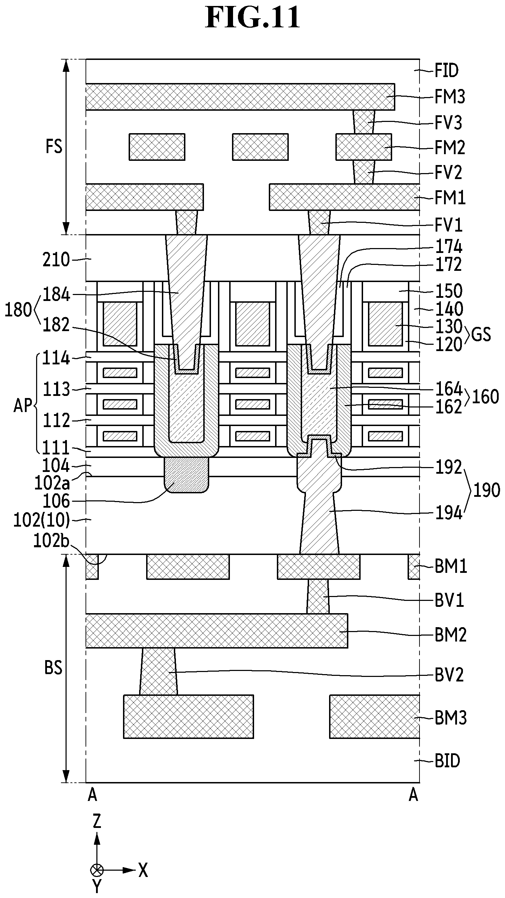

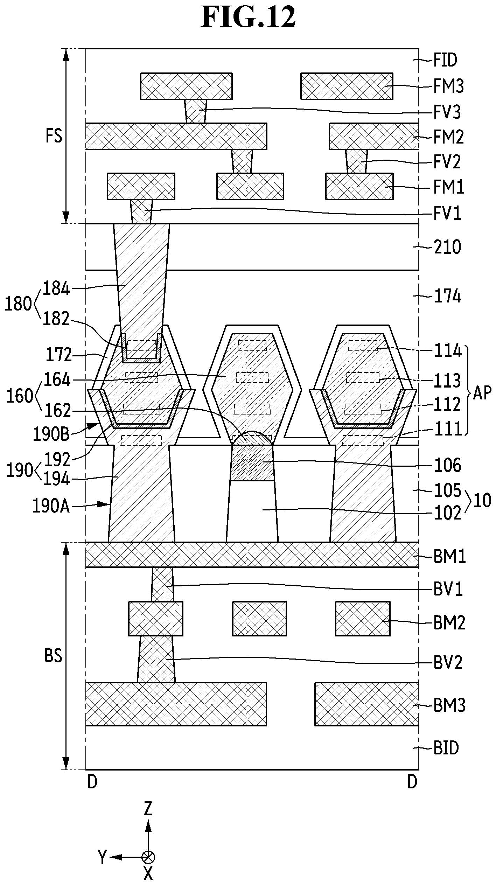

Referring to FIGS. 11 and 12, in a semiconductor device according to one or more embodiments, one source/drain pattern 160 is connected to both the front side source/drain contact 180 and the back side source/drain contact 190. For reference, FIG. 11 is another schematic cross-sectional view taken along A-A of FIG. 1, and FIG. 12 is another schematic cross-sectional view taken along D-D of FIG. 1.

For example, the front side source/drain contact 180 may be in direct contact with the upper part of one source/drain pattern 160, and the back side source/drain contact 190 may be in direct contact with the lower part of the one source/drain pattern 160. The front side source/drain contact 180 and the back side source/drain contact 190 may overlap in the third direction Z.

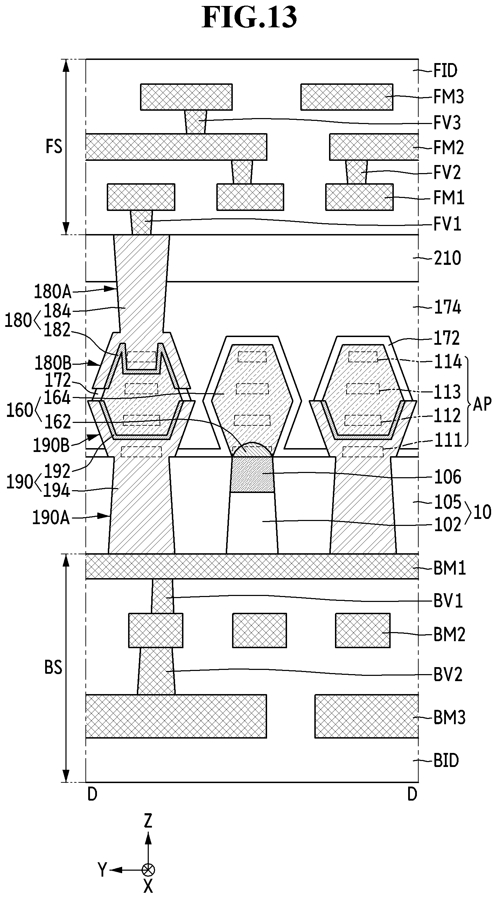

Referring to FIG. 13, in the semiconductor device according to one or more embodiments, the front side source/drain contact 180 includes a second pillar part 180A and a second wrapping part 180B. FIG. 13 is another schematic cross-sectional view taken along D-D of FIG. 1.

The second pillar part 180A sequentially penetrates the second interlayer insulating film 210, the first interlayer insulating film 174, and the etch stop layer 172, and may come into contact with the upper face of the source/drain pattern 160 (160T of FIG. 6). The width of the second pillar part 180A may decrease toward the source/drain pattern 160. Here, the width refers to a width in a plane intersecting the third direction Z (e.g., the XY plane).

The second wrapping part 180B may extend from the second pillar part 180A. The second wrapping part 180B may protrude downward beyond the lower part of the second pillar part 180A. The second wrapping part 180B may extend along a part of the side face of the source/drain pattern 160 that intersects the second direction Y. The second wrapping part 180B may come into contact with a part of the side face of the source/drain pattern 160 that intersects the second direction Y.

The second wrapping part 180B is shown as being spaced apart from the first wrapping part 190B by the etch stop layer 172, but this is only an example. Alternatively, the lower part of the second wrapping part 180B may come into contact with the upper part of the first wrapping part 190B.

In one or more embodiments, the lower face of the second wrapping part 180B may come into contact with the etch stop layer 172. For example, the first wrapping part 190B may extend along a part of the side face of the source/drain pattern 160, the etch stop layer 172 may extend from the upper face of the first wrapping part 190B along another part of the side face of the source/drain pattern 160, and the second wrapping part 180B may extend from the upper face of the etch stop layer 172 along still another part of the side face of the source/drain pattern 160.

In one or more embodiments, the first wrapping part 190B may come into contact with the second epitaxial layer 164.

In one or more embodiments, the thickness of the second wrapping part 180B may be greater than the thickness of the etch stop layer 172. For example, a part of the second wrapping part 180B may protrude beyond the etch stop layer 172 toward the source/drain pattern 160. Alternatively, for example, a part of the second wrapping part 180B may protrude beyond the etch stop layer 172 toward the first interlayer insulating film 174.

In one or more embodiments, the second wrapping part 180B may extend along the second side face (160S2 of FIG. 6) of the source/drain pattern 160.

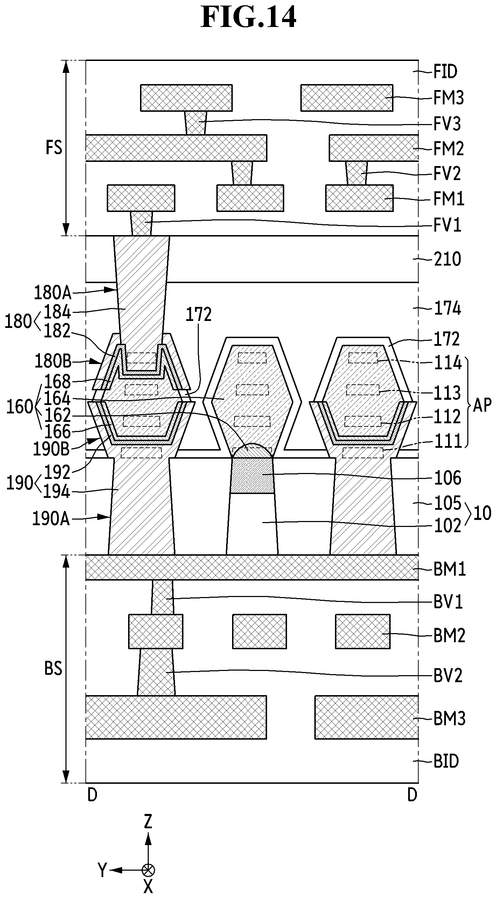

Referring to FIG. 14, in the semiconductor device according to one or more embodiments, the source/drain pattern 160 further includes a fourth epitaxial layer 168. For reference, FIG. 14 is another schematic cross-sectional view taken along D-D of FIG. 1.

The fourth epitaxial layer 168 may be interposed between the second epitaxial layer 164 and the front side source/drain contact 180. The front side source/drain contact 180 may come into contact with the fourth epitaxial layer 168. The fourth epitaxial layer 168 may be formed by an epitaxial growth process that uses the second epitaxial layer 164 as a seed layer.

In one or more embodiments, the impurity concentration of the fourth epitaxial layer 168 may be greater than the impurity concentration of the second epitaxial layer 164. As an example, if the source/drain pattern 160 is provided as a source/drain region of an NFET, the n-type impurity concentration of the fourth epitaxial layer 168 may be greater than the n-type impurity concentration of the second epitaxial layer 164. As another example, if the source/drain pattern 160 is provided as a source/drain region of a PFET, the p-type impurity concentration of the fourth epitaxial layer 168 may be greater than the p-type impurity concentration of the second epitaxial layer 164.

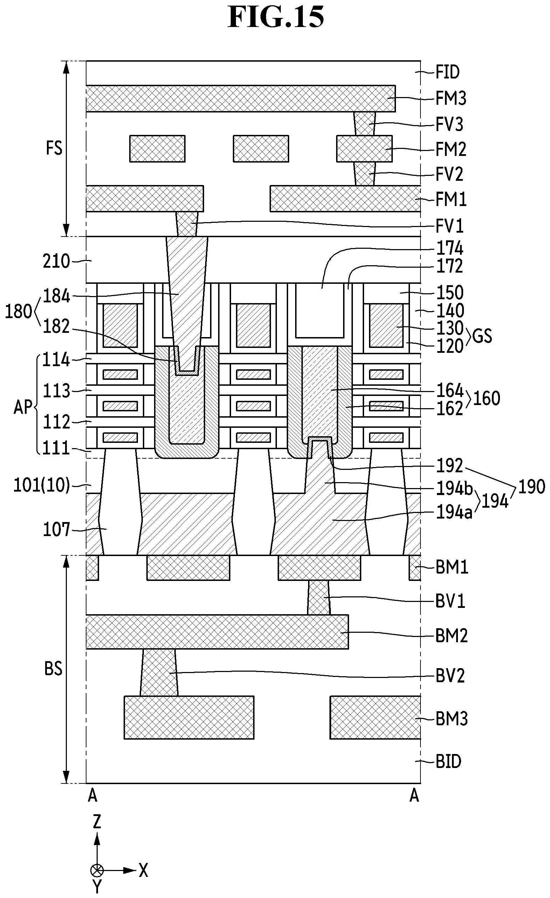

Referring to FIG. 15, a semiconductor device according to one or more embodiments further includes an isolation pattern 107. FIG. 15 is another schematic cross-sectional view taken along A-A of FIG. 1.

The isolation pattern 107 may be formed between the back side wiring structure BS and the active pattern AP and/or between the back side wiring structure BS and the gate structure GS. The isolation pattern 107 may overlap the gate structure GS in the third direction Z.

The isolation pattern 107 may include an insulating material, for example at least one of silicon nitride, silicon oxynitride, silicon oxycarbide, silicon boron nitride, silicon boron carbonitride, silicon oxycarbonitride or a combination thereof, but the disclosure is not limited thereto.

In one or more embodiments, the substrate 10 may include a fin pattern 101. The fin pattern 101 may extend in the first direction X. The fin pattern 101 may include silicon (Si) or germanium (Ge) which are elemental semiconductor materials. As an example, the fin pattern 101 may include a silicon pattern. Alternatively, the fin pattern 101 may include a compound semiconductor, for example a group IV-IV compound semiconductor or a group III-V compound semiconductor.

In one or more embodiments, the back side source/drain contact 190 may include a flat part 194a and a protruding part 194b. The flat part 194a may extend along the second face 102b. The protruding part 194b may protrude from the flat part 194a and be connected to the source/drain pattern 160. For example, the protruding part 194b may protrude from the flat part 194a in the third direction Z and penetrate the substrate 10.

The isolation pattern 107 may cut the substrate 10 and the back side source/drain contacts 190. For example, the isolation pattern 107 may extend long in the second direction Y and cut the fin pattern 101 and the flat part 194a. In one or more embodiments, the isolation pattern 107 may come into contact with the upper face of the back side wiring structure BS and the lower face of the gate structure GS. A plurality of isolation patterns 107 corresponding to a plurality of gate structures GS may extend side by side and spaced apart from each other. A plurality of back side source/drain contacts 190 isolated from each other can be provided, accordingly.

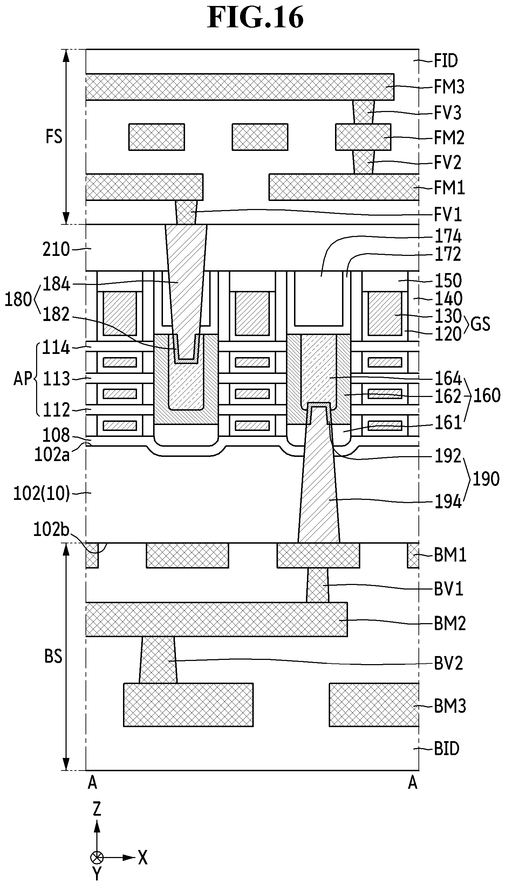

Referring to FIG. 16, in the semiconductor device according to one or more embodiments, the source/drain pattern 160 further includes a stopper layer 161. For reference, FIG. 16 is another schematic cross-sectional view taken along A-A of FIG. 1.

The stopper layer 161 may be formed between the substrate 10 and the first epitaxial layer 162. The back side source/drain contacts 190 may penetrate the stopper layer 161 and come into contact with the first epitaxial layer 162 and/or the second epitaxial layer 164.

The stopper layer 161 may include a semiconductor material or an insulating material. For example, the stopper layer 161 may include at least one of a silicon germanium (SiGe) layer, a silicon carbide (SiC) layer, a silicon nitride (SiN) layer or a combination thereof, but the disclosure is not limited thereto. In one or more embodiments, the first epitaxial layer 162 may be formed by an epitaxial growth process that uses the active pattern AP and the stopper layer 161 as a seed layer.

In one or more embodiments, a liner layer 108 may be formed between the stopper layer 161 and the substrate 10. For example, the liner layer 108 may conformally extend along the profile of the lower face of the gate structure GS, the lower face of the gate spacer 140, and/or the lower face of the stopper layer 161. The liner layer 108 may include an insulating material, for example at least one of silicon nitride, silicon oxynitride, silicon oxycarbide, silicon boron nitride, silicon boron carbonitride, silicon oxycarbonitride or a combination thereof, but the disclosure is not limited thereto.

Hereinafter, a method for fabricating a semiconductor device according to an example embodiment will be described with reference to FIGS. 1 to 47.

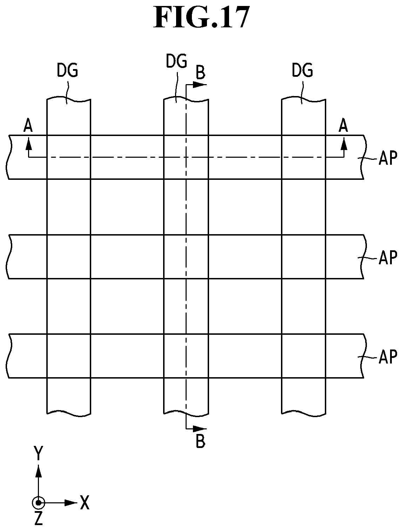

FIGS. 17 to 43 are intermediate stage diagrams for explaining the method for fabricating the semiconductor device according to one or more embodiments. For convenience of explanation, repeated parts of the contents explained above using FIGS. 1 to 14 will be briefly explained or omitted.

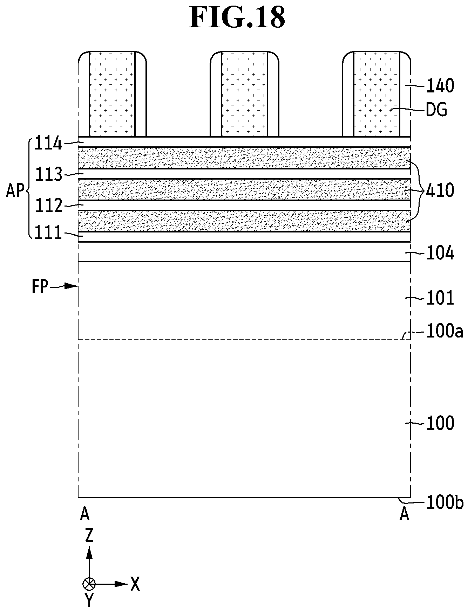

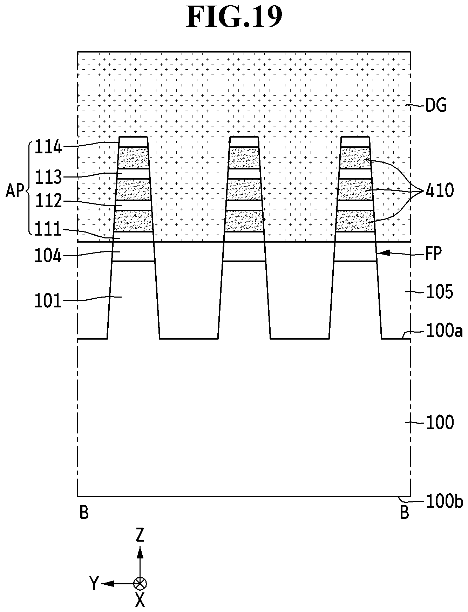

Referring to FIGS. 17 to 19, a fin structure FP, a field insulating film 105, a dummy gate DG, and a gate spacer 140 are formed on a base substrate 100. For reference, FIG. 18 is a schematic cross-sectional view taken along A-A of FIG. 17, and FIG. 19 is a schematic cross-sectional view taken along B-B of FIG. 17.

The base substrate 100 may be bulk silicon or silicon-on-insulator (SOI). In contrast, the base substrate 100 may be a silicon substrate, or may include other materials, for example silicon germanium, silicon germanium-on-insulator (SGOI), indium antimonide, lead telluride, indium arsenide, indium phosphide, gallium arsenide or gallium antimonide, but the disclosure is not limited thereto. For convenience of explanation, the base substrate 100 will be described below as a silicon substrate.

The base substrate 100 may include a third side 100a and a fourth side 100b that are opposite to each other. In this specification, the third side 100a may also be referred to as a front side of the base substrate 100, and the fourth side 100b may also be referred to as a back side of the base substrate 100.

The fin structure FP may be formed on the third side 100a of the base substrate 100. The fin structure FP may extend long in the first direction X. A plurality of fin structures FP may extend side by side in the first direction X.

The fin structure FP may include a fin pattern 101, an active pattern AP, and a sacrificial pattern 410.

The fin pattern 101 may protrude from the third side 100a of the base substrate 100 and extend in the first direction X. The fin pattern 101 may be formed by etching a part of the base substrate 100, or may be an epitaxial layer that is grown from the base substrate 100.

The active pattern AP and the sacrificial pattern 410 may be alternately stacked on the upper face of the fin pattern 101. For example, the fin structure FP may include a plurality of bridge patterns (e.g., first to fourth bridge patterns 111 to 114) and a plurality of sacrificial patterns 410 that are alternately stacked. The first to fourth bridge patterns 111 to 114 may be spaced apart from one another in the third direction Z by the sacrificial patterns 410.

The sacrificial patterns 410 may have an etching selectivity relative to the active patterns AP. As an example, when the active pattern AP includes a silicon (Si) layer, the sacrificial pattern 410 may include a silicon germanium (SiGe) layer.

In one or more embodiments, the fin structure FP may further include a buffer pattern 104. The buffer pattern 104 may be interposed between the fin pattern 101 and the active pattern AP and/or between the fin pattern 101 and the sacrificial pattern 410.

The base substrate 100 and the fin pattern 101 may have an etching selectivity relative to the buffer pattern 104. As an example, when the base substrate 100 and the fin pattern 101 each include a silicon (Si) layer, the buffer pattern 104 may include a silicon germanium (SiGe) layer.

The field insulating film 105 may cover at least a part of the side face of the fin pattern 101. For example, the field insulating film 105 may fill a space between the fin patterns 101 spaced apart along the second direction Y.

The dummy gate DG may be formed on the field insulating film 105 and the fin structure FP. The dummy gate DG may intersect the active pattern AP. For example, the dummy gate DG may extend long in the second direction Y. A plurality of dummy gates DG may extend side by side in the second direction Y. The dummy gate DG may have an etching selectivity relative to to the active pattern AP. As an example, the dummy gate DG may include polysilicon (poly Si).

The gate spacer 140 may extend in the second direction Y along the side face of the dummy gate DG.

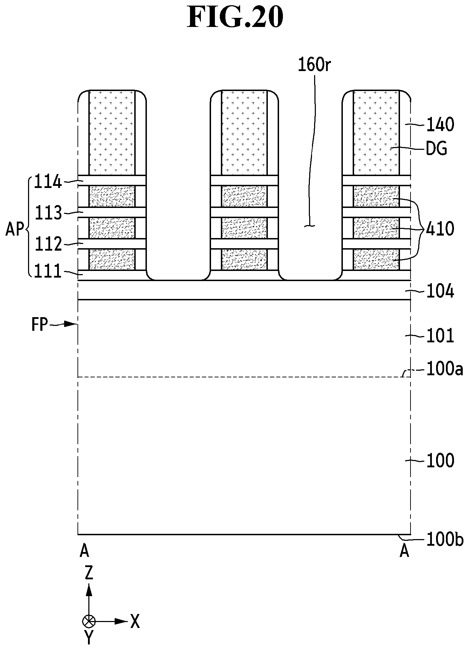

Referring to FIG. 20, a source/drain recess 160r is formed inside the fin structure FP on the side face of the dummy gate DG.

For example, a first recess process may be performed on the active pattern AP and the sacrificial pattern 410, using the dummy gate DG and the gate spacer 140 as an etch mask. As the first recess process is performed, a part of the active pattern AP and a part of the sacrificial pattern 410 may be removed to form the source/drain recess 160r.

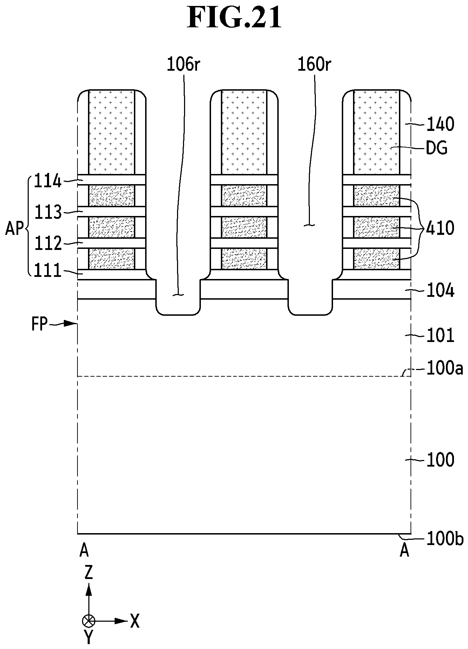

Referring to FIG. 21, a holder recess 106r is formed inside the fin structure FP below the source/drain recess 160r.

For example, a second recess process may be performed on the buffer pattern 104 exposed by the source/drain recess 160r. As the second recess process is performed, a part of the buffer pattern 104 may be removed to form the holder recess 106r. The holder recess 106r may overlap the source/drain recess 160r in the third direction Z.

In one or more embodiments, a part of the fin pattern 101 may be removed in the course of performing the second recess process. For example, the lowermost face of the holder recess 106r may be formed to be lower than the upper face of the fin pattern 101.

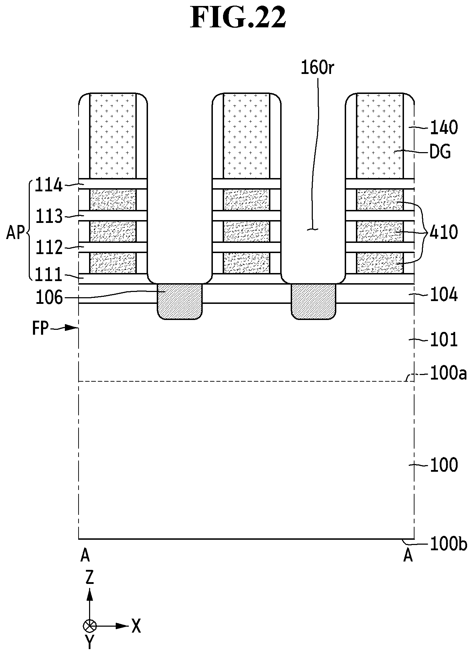

Referring to FIGS. 21 and 22, a holder pattern 106 that fills the holder recess 106r is formed.

For example, an epitaxial growth process of using the fin pattern 101 and the buffer pattern 104 as seed layers may be performed. The base substrate 100 and the fin pattern 101 may have an etching selectivity relative to the holder pattern 106. As an example, when the base substrate 100 and the fin pattern 101 each include a silicon (Si) layer, the holder pattern 106 may include a silicon germanium (SiGe) layer.

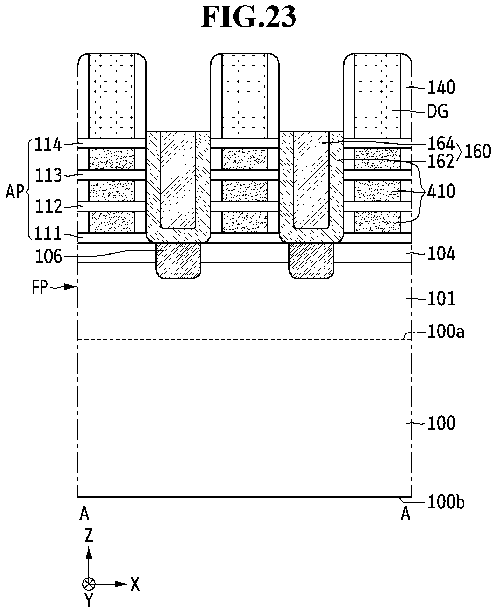

Referring to FIGS. 22 and 23, a source/drain pattern 160 which fills the source/drain recess 160r is formed.

For example, an epitaxial growth process of using the active pattern AP and the holder pattern 106 as seed layers may be performed. Accordingly, the source/drain pattern 160 connected to the active pattern AP may be formed. Also, the source/drain pattern 160 may overlap the holder pattern 106 in the third direction Z.

In one or more embodiments, the source/drain pattern 160 may include a first epitaxial layer 162 and a second epitaxial layer 164 that are sequentially stacked on the active pattern AP and the holder pattern 106. The impurity concentration of the second epitaxial layer 164 may be greater than the impurity concentration of the first epitaxial layer 162.

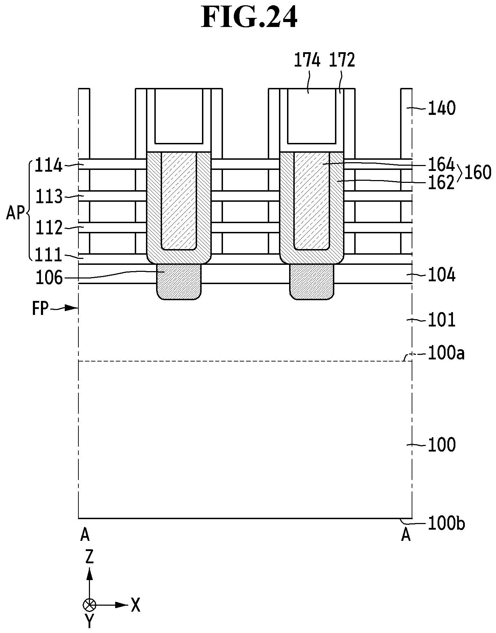

Referring to FIG. 24, the sacrificial pattern 410 and the dummy gate DG are removed.

For example, the etch stop layer 172 and the first interlayer insulating film 174 may be sequentially formed on the dummy gate DG, the gate spacer 140, and the source/drain pattern 160. Next, a planarization process may be performed on the etch stop layer 172 and the first interlayer insulating film 174 to expose the upper face of the dummy gate DG. Next, the exposed dummy gate DG may be removed. As explained above, the dummy gate DG may have an etching selectivity relative to the active pattern AP, and therefore may be selectively removed. Furthermore, as the dummy gate DG is removed, the sacrificial pattern 410 may be exposed.

The exposed sacrificial pattern 410 may then be removed. As explained above, the sacrificial pattern 410 may have an etching selectivity relative to the active pattern AP, and therefore may be selectively removed. Accordingly, the active pattern AP including the first to fourth bridge patterns 111 to 114 may be formed.

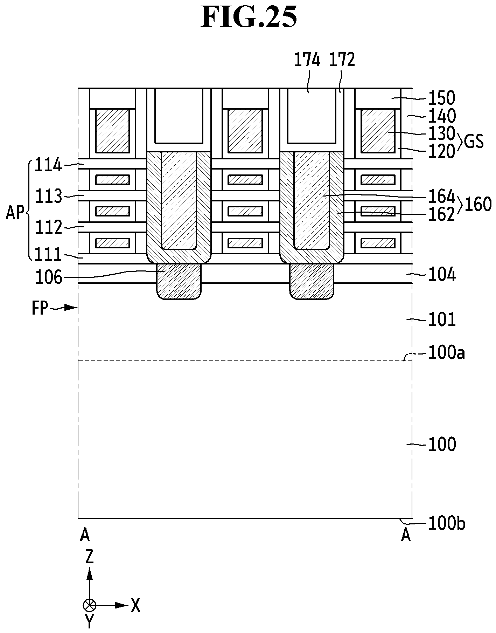

Referring to FIG. 25, a gate structure GS is formed.

For example, a gate dielectric film 120 and a gate electrode 130 may be sequentially stacked on the active pattern AP. Accordingly, the gate structure GS that replaces the dummy gate DG and intersects the active pattern AP may be formed.

In one or more embodiments, the upper part of the gate structure GS may be recessed. Next, the gate capping film 150 may be formed on the upper face of the recessed gate structure GS.

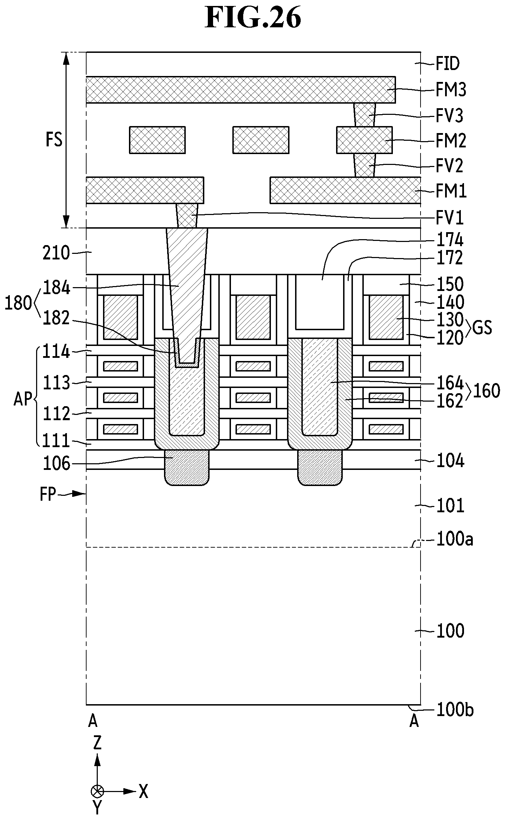

Referring to FIG. 26, the front side source/drain contact 180 and the front side wiring structure FS are formed.

For example, a second interlayer insulating film 210 that covers the upper face of the first interlayer insulating film 174 and the upper face of the gate capping film 150 may be formed. Next, the front side source/drain contact 180 that extends in the third direction Z and sequentially penetrates the second interlayer insulating film 210, the first interlayer insulating film 174, and the etch stop layer 172 may be formed. The front side source/drain contact 180 may be in direct contact with the source/drain pattern 160.

In one or more embodiments, the front side source/drain contact 180 may include a first silicide film 182 and a first metal film 184 that are sequentially stacked on the source/drain pattern 160.

Next, the front side wiring structure FS may be formed on the upper face of the second interlayer insulating film 210 and the upper face of the front side source/drain contact 180. The front side wiring structure FS may be electrically connected to the front side source/drain contact 180.

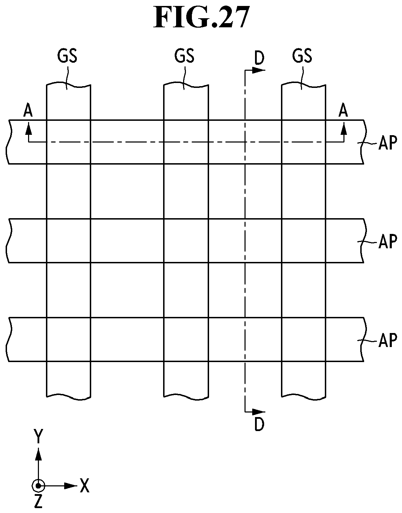

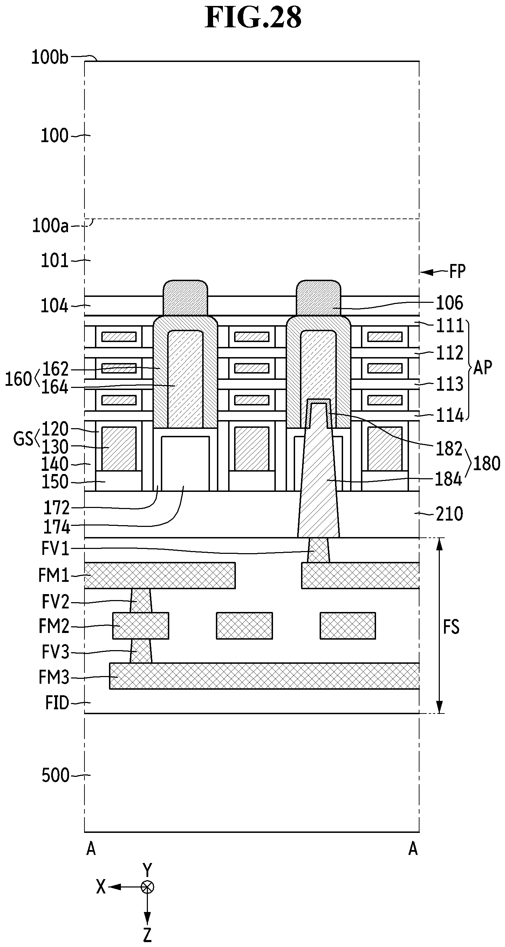

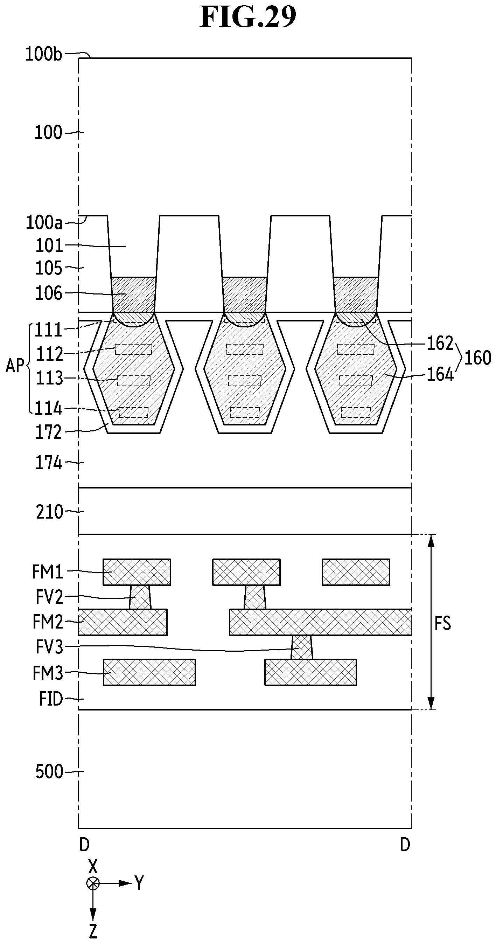

Referring to FIGS. 27 to 29, the front side wiring structure FS is attached onto the carrier substrate 500. For reference, FIG. 28 is a schematic cross-sectional view taken along A-A of FIG. 27, and FIG. 29 is a schematic cross-sectional view taken along D-D of FIG. 27.

For example, the carrier substrate 500 may be attached onto the product of FIG. 26. After the carrier substrate 500 is attached, the product of FIG. 26 may be inverted. That is, the fourth side 100b of the base substrate 100 may face upward. In one or more embodiments, the front side wiring structure FS may be attached onto the carrier substrate 500 by an oxide-oxide bonding process.

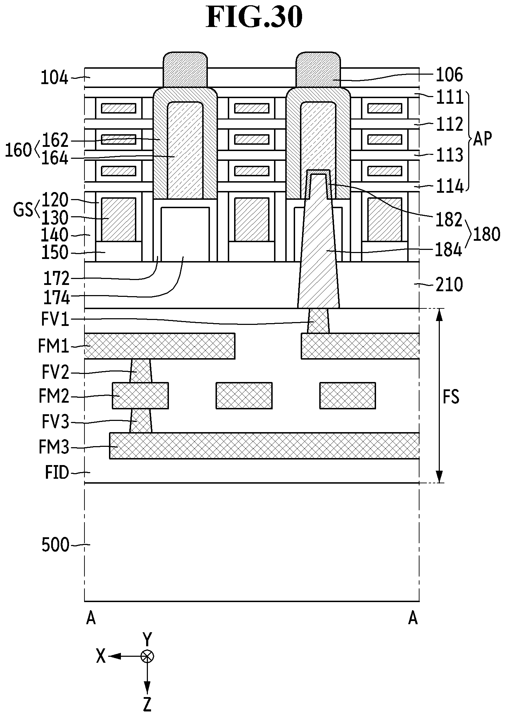

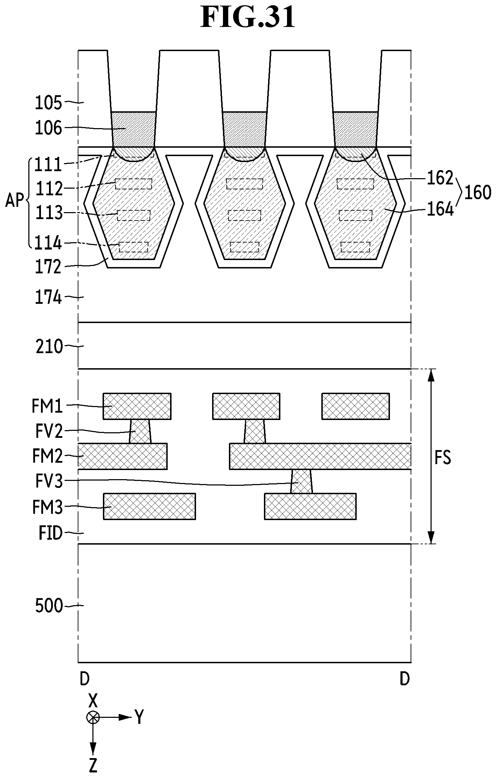

Referring to FIGS. 30 and 31, the base substrate 100 and the fin pattern 101 are removed.

For example, the base substrate 100 and the fin pattern 101 may be subjected to a grinding process and/or an etching process. In the course of removing the base substrate 100 and the fin pattern 101, the buffer pattern 104 may be provided as an etch stop layer. Also, the base substrate 100 and the fin pattern 101 may be selectively removed with respect to the field insulating film 105, the buffer pattern 104, and the holder pattern 106.

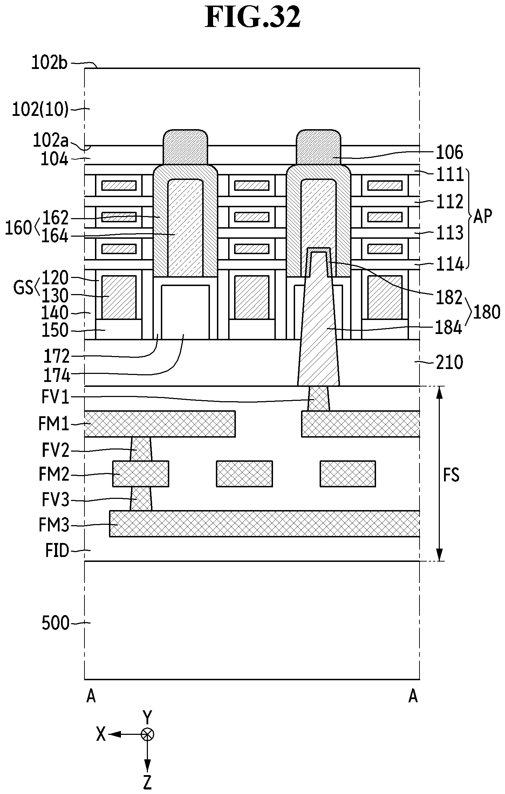

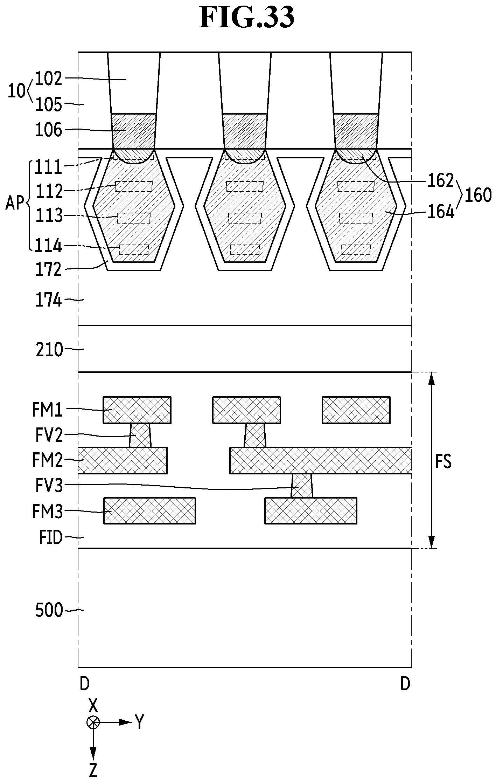

Referring to FIGS. 32 and 33, a plurality of base patterns 102 are formed.

The base patterns 102 may fill the region from which the fin pattern 101 is removed. In one or more embodiments, each base pattern 102 may include an insulating material. Accordingly, the substrate 10 including an insulating material may be provided.

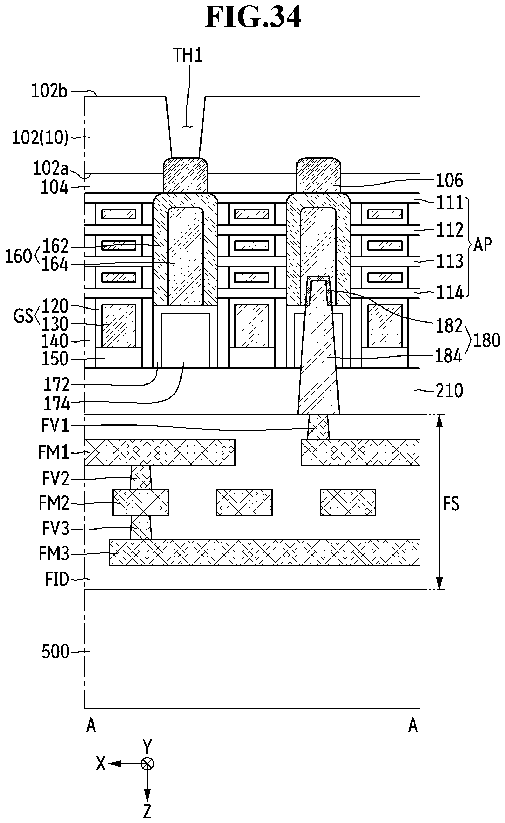

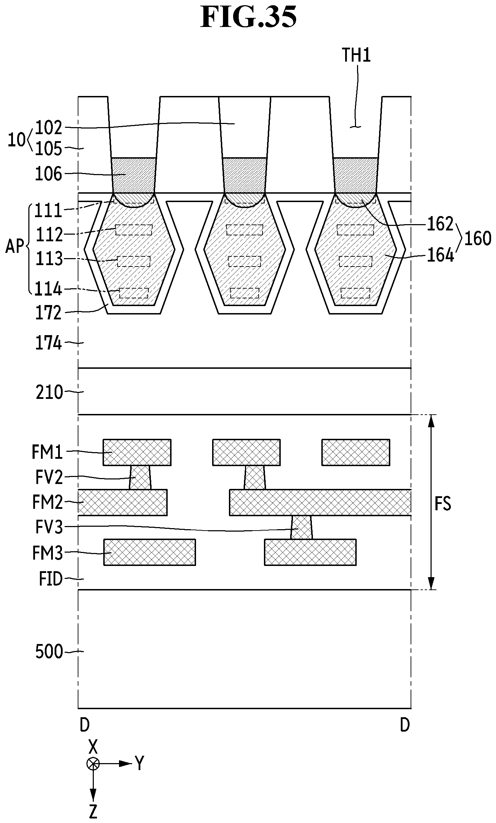

Referring to FIGS. 34 and 35, a first contact hole TH1 is formed inside the substrate 10.

For example, an etching process may be performed on at least a part of the base pattern 102. The first contact hole TH1 may extend in the third direction Z and penetrate the substrate 10. Also, the first contact hole TH1 may expose at least a part of the plurality of holder patterns 106.

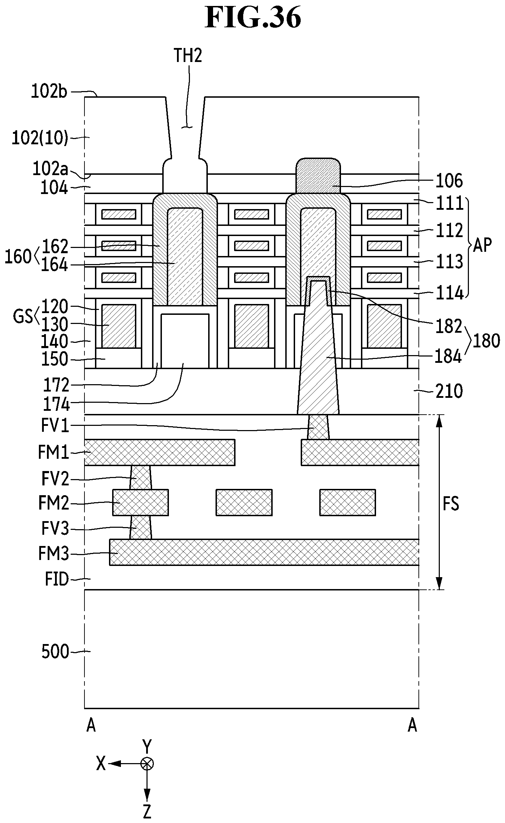

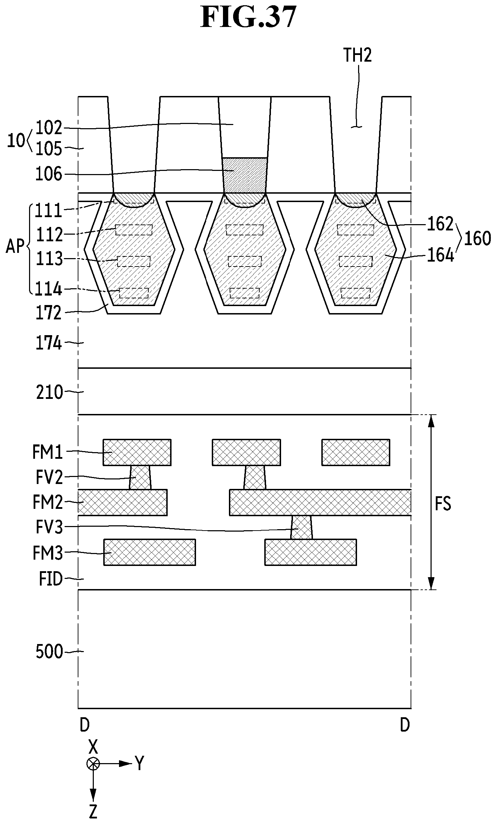

Referring to FIGS. 36 and 37, a second contact hole TH2 is formed inside the substrate 10 and the buffer pattern 104.

For example, the holder pattern 106 exposed by the first contact hole TH1 may be removed. The second contact hole TH2 may extend in the third direction Z and penetrate the substrate 10 and the buffer pattern 104. The second contact hole TH2 may also expose at least a part of the plurality of source/drain patterns 160. In one or more embodiments, the second contact hole TH2 may expose an upper face of the first epitaxial layer 162.

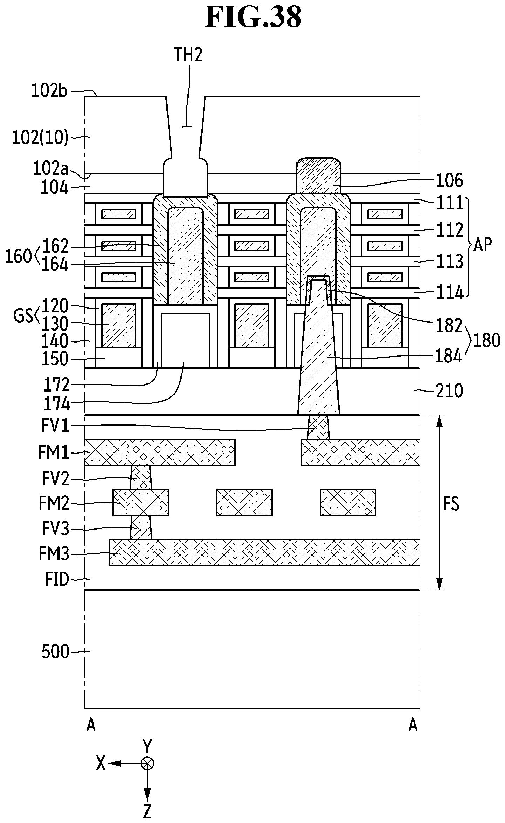

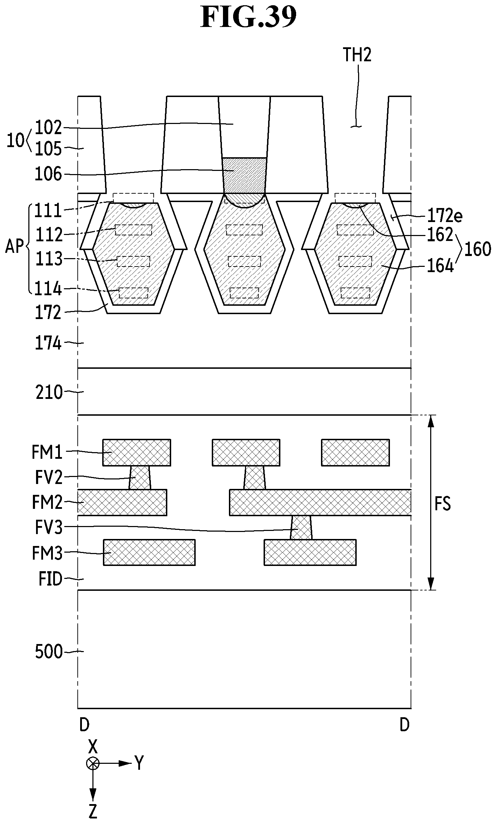

Referring to FIGS. 38 and 39, a wrapping recess 172e is formed inside the etch stop layer 172.

For example, a third recess process may be performed on the etch stop layer 172, using the second contact hole TH2. As the third recess process is performed, a part of the etch stop layer 172 may be removed to form the wrapping recess 172e. The wrapping recess 172e may expose at least a part of a side face of the source/drain pattern 160. In one or more embodiments, the wrapping recess 172e may expose at least a part of the side face of the second epitaxial layer 164.

In one or more embodiments, a part of the substrate 10, a part of the source/drain pattern 160, and/or a part of the first interlayer insulating film 174 may be removed in the course of performing the third recess process. In such a case, the width of the second contact hole TH2 may be greater than the width of the base pattern 102. Alternatively, the thickness of the wrapping recess 172e may be greater than the thickness of the etch stop layer 172.

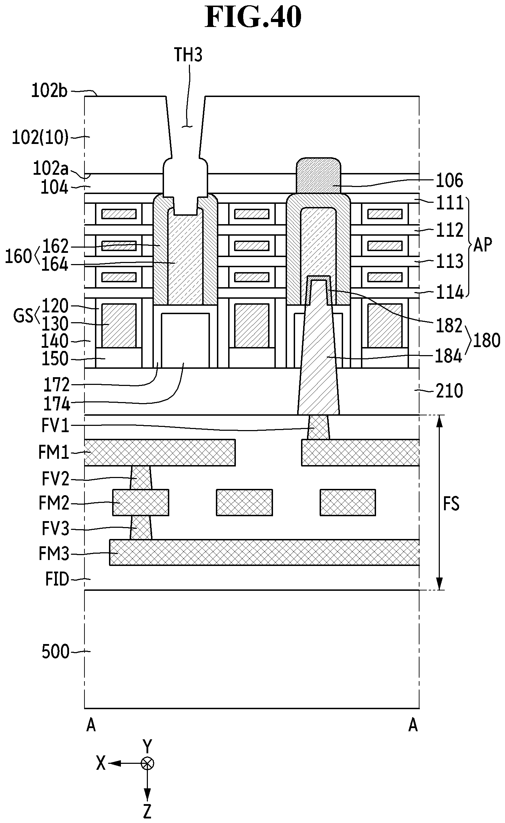

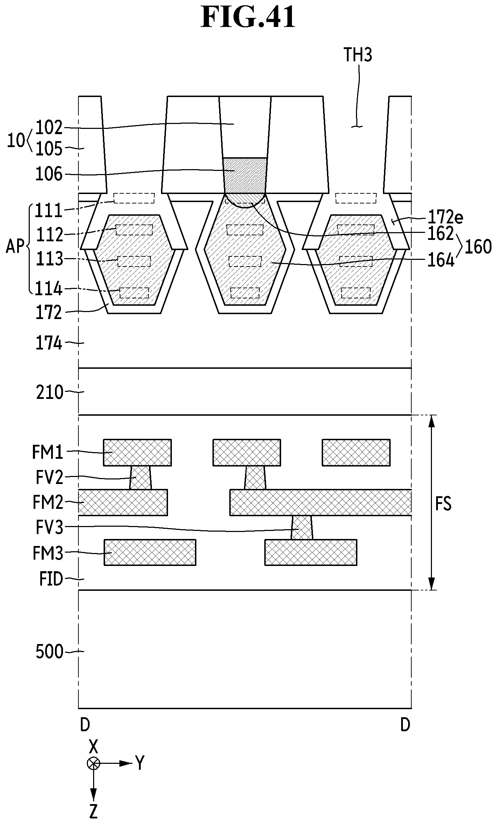

Referring to FIGS. 40 and 41, a third contact hole TH3 is formed.

For example, the source/drain pattern 160 exposed by the second contact hole TH2 may be additionally etched. The third contact hole TH3 may extend in the third direction Z and penetrate the substrate 10 and the buffer pattern 104. The third contact hole TH3 may also expose at least a part of the source/drain pattern 160. In one or more embodiments, the third contact hole TH3 may expose at least a part of the upper face of the second epitaxial layer 164.

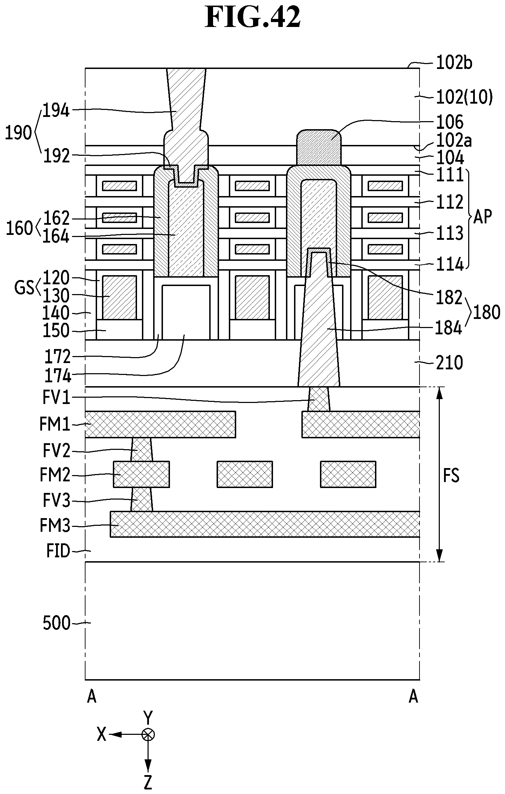

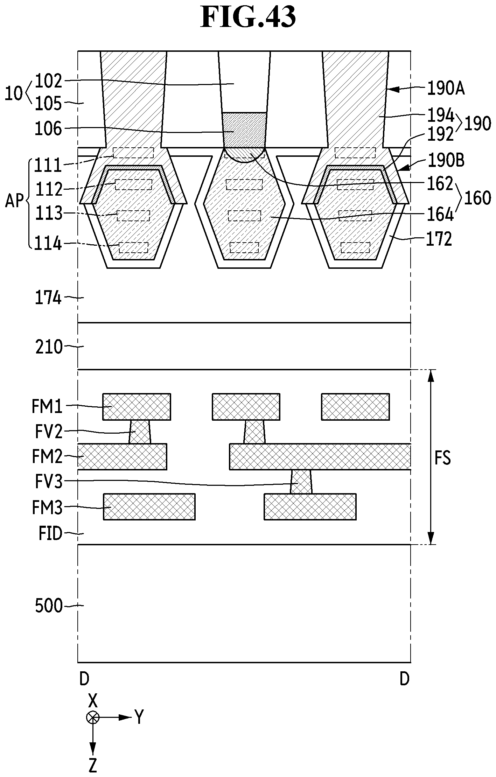

Referring to FIGS. 42 and 43, a back side source/drain contact 190 is formed.

The back side source/drain contact 190 may fill the third contact hole TH3 and the wrapping recess 172e. The back side source/drain contact 190 including a first pillar part 190A and a first wrapping part 190B may be provided, accordingly.

In one or more embodiments, the back side source/drain contact 190 may include a second silicide film 192 and a second metal film 194 that are sequentially stacked on the source/drain pattern 160.

Next, referring to FIGS. 2 and 5, the back side wiring structure BS is formed on the back side of the substrate 10. The semiconductor device explained above using FIGS. 1 to 6 may be fabricated, accordingly.

Although only the formation of the back side source/drain contact 190 using the holder pattern 106 is explained above, this is example, and the holder pattern 106 may be omitted.

For example, as explained above referring to FIG. 15, the back side source/drain contact 190 may be formed, by using the isolation pattern 107. In such a case, unlike that explained referring to FIGS. 30 and 31, only a part of the base substrate 100 and/or a part of the fin pattern 101 may be removed.

Alternatively, as explained above referring to FIG. 16, for example, the back side source/drain contact 190 may be formed, using the stopper layer 161. In such a case, the stopper layer 161 may prevent the source/drain contact 190 from being damaged in the course of removing the base substrate 100 and the fin pattern 101 (see FIGS. 30 and 31).

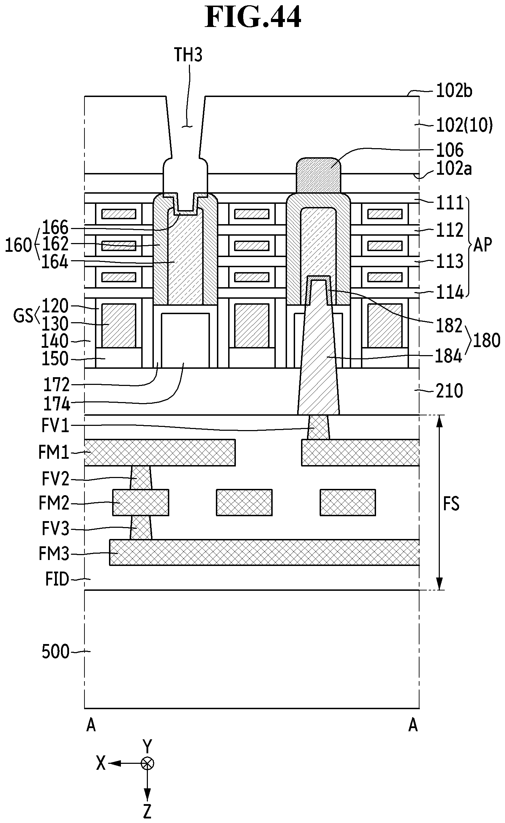

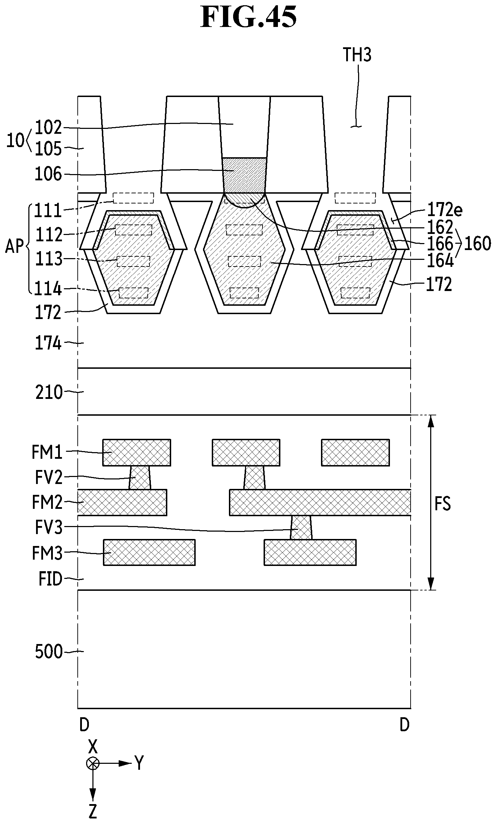

FIGS. 44 to 47 are intermediate stage diagrams for explaining a method for fabricating a semiconductor device according to one or more embodiments. For convenience of explanation, repeated parts of contents explained above using FIGS. 1 to 43 will be briefly explained or omitted. For reference, FIGS. 44 and 45 are intermediate stage diagrams for explaining the stages subsequent to FIGS. 40 and 41.

Referring to FIGS. 44 and 45, a third epitaxial layer 166 is formed.

For example, an epitaxial growth process of using the first epitaxial layer 162 and the second epitaxial layer 164 exposed by the third contact hole TH3 and the wrapping recess 172e as a seed layer may be performed. In one or more embodiments, the impurity concentration of the third epitaxial layer 166 may be higher than the impurity concentration of the first epitaxial layer 162.

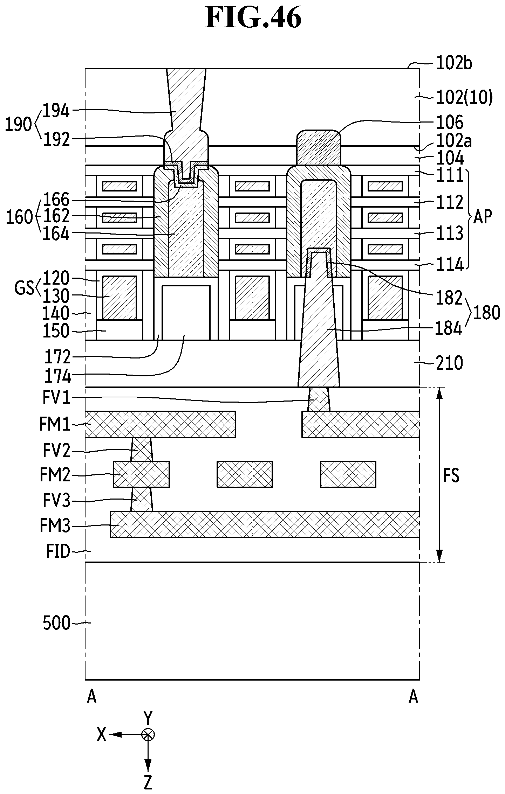

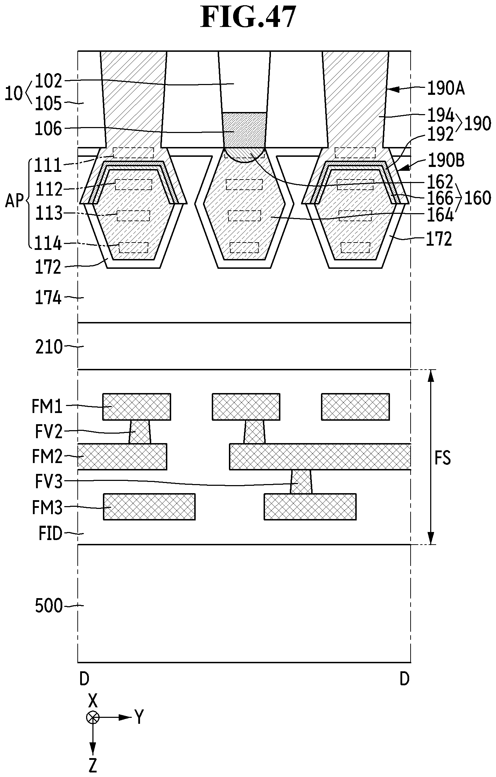

Referring to FIGS. 46 and 47, the back side source/drain contact 190 is formed. The formation of the back side source/drain contact 190 is similar to that explained above using FIGS. 42 and 43, and therefore, the detailed description will not be provided below.

Next, referring to FIGS. 8 and 9, the back side wiring structure BS is formed on the back side of the substrate 10. The semiconductor device explained above using FIGS. 8 to 10 can be fabricated, accordingly.

Embodiments are set out in the following clauses:
Clause 1.A semiconductor device comprising: a substrate; an active pattern on an upper side of the substrate; a gate structure on the active pattern and intersecting the active pattern; a source/drain pattern on a side face of the gate structure and connected to the active pattern; an etch stop layer extending along an upper side of the substrate and an outer face of the source/drain pattern; a back side source/drain contact in the substrate, the back side source/drain contact being connected to the source/drain pattern; and a back side wiring structure on a lower side of the substrate and connected to the back side source/drain contact, wherein the back side source/drain contact extends along at least a part of a side face of the source/drain pattern, and wherein a part of the back side source/drain contact farthest from the lower side of the substrate is in contact with the etch stop layer.
Clause 2. The semiconductor device of clause 1, wherein the source/drain pattern comprises a first epitaxial layer and a second epitaxial layer which, wherein the first and the second epitaxial layers are sequentially stacked on the substrate and the active pattern, and wherein an impurity concentration of the second epitaxial layer is larger than an impurity concentration of the first epitaxial layer.
Clause 3. The semiconductor device of clause 2, wherein the back side source/drain contact is in contact with the second epitaxial layer.
Clause 4. The semiconductor device of any preceding clause, wherein the back side source/drain contact comprises; a pillar in the substrate, the pillar being in contact with a lower face of the source/drain pattern; and a wrapping part which protrudes beyond an upper face of the pillar and is in contact with at least a part of the side face of the source/drain pattern.
Clause 5. The semiconductor device of any preceding clause, wherein the back side source/drain contact comprises a silicide film and a metal film which are sequentially stacked on the source/drain pattern.
Clause 6. The semiconductor device of any preceding clause, further comprising: an interlayer insulating film on the etch stop layer; a front side source/drain contact in the etch stop layer and the interlayer insulating film, and the front side source/drain contact being connected to the source/drain pattern; and a front side wiring structure on the interlayer insulating film and connected to the front side source/drain contact.
Clause 7. The semiconductor device of clause 6, wherein the front side source/drain contact extends along a part of the side face of the source/drain pattern different from the part of the side face of the source/drain pattern along which the back side source/drain contact extends.
Clause 8. The semiconductor device of any preceding clause, wherein the etch stop layer extends along the side face of the gate structure.
Clause 9. The semiconductor device of any preceding clause, wherein the active pattern comprises a plurality of bridge patterns which are sequentially stacked on the upper side of the substrate, are spaced apart from each other, and each are in the gate structure.
Clause 10. A semiconductor device comprising: a substrate; an active pattern on an upper side of the substrate and extending in a first direction; a gate structure on the active pattern and extending in a second direction intersecting the first direction; a source/drain pattern on a side face of the gate structure and connected to the active pattern; an etch stop layer extending along the upper side of the substrate and an outer face of the source/drain pattern; a back side wiring structure on a lower side of the substrate; and a back side source/drain contact which connects the source/drain pattern and the back side wiring structure, wherein the back side source/drain contact comprises: a first pillar in the substrate, the first pillar being in contact with a lower face of the source/drain pattern; and a first wrapping part which protrudes beyond an upper face of the first pillar and extends along at least a part of a side face of the source/drain pattern, and wherein the first wrapping part is in contact with the etch stop layer.
Clause 11. The semiconductor device of clause 10, wherein the source/drain pattern comprises a first epitaxial layer and a second epitaxial layer, wherein the first and the second epitaxial layers are sequentially stacked on the substrate and the active pattern, and wherein an impurity concentration of the second epitaxial layer is larger than an impurity concentration of the first epitaxial layer.
Clause 12. The semiconductor device of clause 11, wherein the first epitaxial layer is not between the first wrapping part and the second epitaxial layer.
Clause 13. The semiconductor device of clause 10, 11 or 12, wherein a thickness of the first wrapping part is greater than a thickness of the etch stop layer.
Clause 14. The semiconductor device of any one of clauses 10 to 13, wherein a cross section of the source/drain pattern intersecting the first direction comprises: a first side face which extends from the lower face of the source/drain pattern and forms an obtuse angle with the lower face of the source/drain pattern; and a second side face which extends from an upper face of the source/drain pattern and forms an obtuse angle with the upper face of the source/drain pattern, and wherein the first wrapping part is in contact with the first side face.
Clause 15. The semiconductor device of clause 14, wherein the etch stop layer is in contact with the second side face.
Clause 16. The semiconductor device of any one of clauses 10 to 15, further comprising: an interlayer insulating film on the etch stop layer; a front side wiring structure on the interlayer insulating film; and a front side source/drain contact which connects the source/drain pattern and the front side wiring structure.
Clause 17. The semiconductor device of clause 16, wherein the front side source/drain contact comprises: a second pillar in the interlayer insulating film and the etch stop layer, the second pillar being in contact with the upper face of the source/drain pattern; and a second wrapping part which protrudes beyond a lower face of the second pillar and extends along a part of the side face of the source/drain pattern different from the part of the side face of the source/drain pattern along which the first wrapping part extends.
Clause 18. A semiconductor device comprising; a substrate; a plurality of bridge patterns which are sequentially stacked on an upper side of the substrate, are spaced apart from each other, and extend in a first direction; a gate structure which extends in a second direction intersecting the first direction, wherein the plurality of bridge patterns are in the gate structure; a source/drain pattern on a side face of the gate structure and connected to the plurality of bridge patterns; an etch stop layer extending along the upper side of the substrate, the side face of the gate structure, and an outer face of the source/drain pattern; a back side wiring structure on a lower side of the substrate; and a back side source/drain contact which connects the source/drain pattern and the back side wiring structure, wherein the source/drain pattern comprises a first epitaxial layer and a second epitaxial layer, where in the first and the second epitaxial layers are sequentially stacked on the substrate and the plurality of bridge patterns, wherein an impurity concentration of the second epitaxial layer is larger than an impurity concentration of the first epitaxial layer, wherein the back side source/drain contact comprises: a first pillar in the substrate, the first pillar being in contact with a lower face of the source/drain pattern; and a first wrapping part that protrudes beyond an upper face of the first pillar, wherein the first wrapping part extends along a part of a side face of the second epitaxial layer, and wherein the etch stop layer extends from an upper face of the first wrapping part along a part of the side face of the second epitaxial layer different from the part of the side face of the second epitaxial layer along which the first wrapping part extends.
Clause 19. The semiconductor device of clause 18, further comprising: an interlayer insulating film on the etch stop layer; a front side wiring structure on the interlayer insulating film; and a front side source/drain contact which connects the source/drain pattern and the front side wiring structure.
Clause 20. The semiconductor device of clause 19, wherein the front side source/drain contact comprises: a second pillar in the interlayer insulating film and the etch stop layer, the second pillar being in contact with an upper face of the source/drain pattern; and a second wrapping part that protrudes beyond a lower face of the second pillar, and wherein the second wrapping part extends from the upper face of the etch stop layer along a part of the side face of the second epitaxial layer different from the part of the side face of the second epitaxial layer along which the first wrapping part extends.

Although embodiments of the present disclosure have been described with reference to the accompanying drawings, the present disclosure is not limited to the above embodiments but may be implemented in various different forms. A person skilled in the art may appreciate that the present disclosure may be practiced in other concrete forms without changing the essential characteristics of the present disclosure. Therefore, it should be appreciated that the embodiments as described above are not restrictive but illustrative in all respects.

## Claims

1. A semiconductor device comprising:
a substrate;
an active pattern on an upper side of the substrate;
a gate structure on the active pattern and intersecting the active pattern;
a source/drain pattern on a side face of the gate structure and connected to the active pattern;
an etch stop layer extending along an upper side of the substrate and an outer face of the source/drain pattern;
a back side source/drain contact in the substrate, the back side source/drain contact being connected to the source/drain pattern; and
a back side wiring structure on a lower side of the substrate and connected to the back side source/drain contact,
wherein the back side source/drain contact extends along at least a part of a side face of the source/drain pattern, and
wherein a part of the back side source/drain contact farthest from the lower side of the substrate is in contact with the etch stop layer.

2. The semiconductor device of claim 1,
wherein the source/drain pattern comprises a first epitaxial layer and a second epitaxial layer, wherein the first and the second epitaxial layers are sequentially stacked on the substrate and the active pattern, and
wherein an impurity concentration of the second epitaxial layer is larger than an impurity concentration of the first epitaxial layer.

3. The semiconductor device of claim 2,
wherein the back side source/drain contact is in contact with the second epitaxial layer.

4. The semiconductor device of any preceding claim,
wherein the back side source/drain contact comprises;
a pillar in the substrate, the pillar being in contact with a lower face of the source/drain pattern; and
a wrapping part which protrudes beyond an upper face of the pillar and is in contact with at least a part of the side face of the source/drain pattern.

5. The semiconductor device of any preceding claim,
wherein the back side source/drain contact comprises a silicide film and a metal film which are sequentially stacked on the source/drain pattern.

6. The semiconductor device of any preceding claim, further comprising:
an interlayer insulating film on the etch stop layer;
a front side source/drain contact in the etch stop layer and the interlayer insulating film, and the front side source/drain contact being connected to the source/drain pattern; and
a front side wiring structure on the interlayer insulating film and connected to the front side source/drain contact.

7. The semiconductor device of claim 6,
wherein the front side source/drain contact extends along a part of the side face of the source/drain pattern different from the part of the side face of the source/drain pattern along which the back side source/drain contact extends.

8. The semiconductor device of any preceding claim,
wherein the etch stop layer extends along the side face of the gate structure.

9. The semiconductor device of claim 1, wherein:
the active pattern extends in a first direction;
the gate structure extends in a second direction intersecting the first direction;
wherein the back side source/drain contact comprises:
a first pillar in the substrate, the first pillar being in contact with a lower face of the source/drain pattern; and
a first wrapping part which protrudes beyond an upper face of the first pillar and extends along at least a part of the side face of the source/drain pattern, and
wherein the first wrapping part is in contact with the etch stop layer.

10. The semiconductor device of claim 9,
wherein the source/drain pattern comprises a first epitaxial layer and a second epitaxial layer, wherein the first and the second epitaxial layers are sequentially stacked on the substrate and the active pattern, and
wherein an impurity concentration of the second epitaxial layer is larger than an impurity concentration of the first epitaxial layer.

11. The semiconductor device of claim 10,
wherein the first epitaxial layer is not between the first wrapping part and the second epitaxial layer.

12. The semiconductor device of any one of claims 9, 10 or 11,
wherein a thickness of the first wrapping part is greater than a thickness of the etch stop layer.

13. The semiconductor device of any one of claims 9 to 12,
wherein a cross section of the source/drain pattern intersecting the first direction comprises:
a first side face which extends from the lower face of the source/drain pattern and forms an obtuse angle with the lower face of the source/drain pattern; and
a second side face which extends from an upper face of the source/drain pattern and forms an obtuse angle with the upper face of the source/drain pattern, and
wherein the first wrapping part is in contact with the first side face.

14. The semiconductor device of claim 13,
wherein the etch stop layer is in contact with the second side face.

15. The semiconductor device of claim 1, further comprising;
a plurality of bridge patterns which are sequentially stacked on an upper side of the substrate, are spaced apart from each other, and extend in a first direction;
wherein:
the gate structure extends in a second direction intersecting the first direction, and the plurality of bridge patterns are in the gate structure;
the source/drain pattern is connected to the plurality of bridge patterns;
the etch stop layer extends along the side face of the gate structure;
the source/drain pattern comprises a first epitaxial layer and a second epitaxial layer, the first and the second epitaxial layers being sequentially stacked on the substrate and the plurality of bridge patterns, and an impurity concentration of the second epitaxial layer is larger than an impurity concentration of the first epitaxial layer,
wherein the back side source/drain contact comprises:
a first pillar in the substrate, the first pillar being in contact with a lower face of the source/drain pattern; and
a first wrapping part that protrudes beyond an upper face of the first pillar,
wherein the first wrapping part extends along a part of a side face of the second epitaxial layer, and
wherein the etch stop layer extends from an upper face of the first wrapping part along a part of the side face of the second epitaxial layer different from the part of the side face of the second epitaxial layer along which the first wrapping part extends.
